(19) Europäisches Patentamt / European Patent Office / Office européen des brevets

(11) **EP 1 884 791 A1**

(12) **EUROPEAN PATENT APPLICATION**

(43) Date of publication:
06.02.2008 Bulletin 2008/06

(51) Int Cl.:
*G01R 33/035* (2006.01)

(21) Application number: 06118221.8

(22) Date of filing: 31.07.2006

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(71) Applicant: **Hitachi Ltd.**
**Tokyo (JP)**

(72) Inventors:
• **Williams, David**
**Cambridge, CB1 3BE (GB)**
• **Hasko, David**
**Cambridge, CB6 3SU (GB)**
• **Hutchinson, Gregory**
**London, Ontario N5X 2N9 (CA)**
• **Qin, Hua**
**Madison, WI WI-53706 (US)**

(74) Representative: **Piotrowicz, Pawel Jan Andrzej et al**
**Venner Shipley LLP**
**Byron House**
**Cambridge Business Park**
**Cowley Road**
**Cambridge CB4 0WZ (GB)**

(54) **Superconducting quantum interference device**

(57) A superconducting quantum interference device (1) includes two Dayem bridge Josephson junction ($14_1$, $14_2$) and respective phonon generators ($15_1$, $15_2$) associated with each junction for controlling charge carrier transport through the junctions.
The critical currents of the two Josephson junctions can be controlled by irradiation with hot phonons.

Fig. 1

EP 1 884 791 A1

**Description**

The present invention relates to apparatus comprising a superconducting quantum interference device.

A direct current (dc) superconducting quantum interference device (SQUID) comprises two Josephson junctions connected in parallel. A Josephson junction comprises two weakly linked superconductors and can be fabricated, for example, by separating the two superconductors by a thin layer of insulator.

In a dc SQUID, the maximum current that can flow through the two junctions with no voltage drop depends on the strength of the externally applied magnetic field. The maximum current, $I_0$, known as the critical current, is given by Equation (1) below:

$$I_0 = I_c \left| cos(\pi \frac{\Phi}{\Phi_0}) \right| \tag{1}$$

where $I_c$ is the maximum critical current of the superconductor when no magnetic field is present, $\Phi$ is the magnetic flux enclosed by the loop formed by the junctions and $\Phi_0$ is a flux quantum, i.e. $\Phi_0 = b/2e$, where $h$ is Plank's constant and $e$ is electronic charge.

Because the value of $\Phi_0$ is so small, a small change in $\Phi$ can result in a large change in current $I_0$. Thus, a dc SQUID can be used as a sensitive magnetometer having applications in a variety of fields, such as medical imaging.

Micron-sized, dc SQUIDs can be used to measure localised magnetic fields and reference is made to "Micro-SQUID magnetometry and magnetic imaging" by K. Hasselbach, C. Veauvy and D. Mailly, Physica C, pp. 140-147, volume 322 (2000) and "DC-SQUID with aluminium microbridges far from TC" by C. Chapelier, M. El-Khatib, P. Perrier, A. Benoit, D. Mailly, pp. 286-91 Superconducting devices and their applications: Proceedings of the 4th International Conference SQUID '91 (Springer Verlag, Berlin, 1992).

These so-called "microSQUIDs" generally have a loop size of around 1 μm, making them sensitive to fields from nearby small magnetic particles and insensitive to background magnetic fluctuations. Examples of microSQUIDs that are used to make measurements are described in "Switching of magnetization by nonlinear resonance studied in single nanoparticles" by C. Thirion, W. Wernsdorfer and D. Mailly, Nature Materials, pp. 524-527, volume 2 (2003) and "High sensitivity magnetization measurements of nanoscale cobalt clusters" by W. Wernsdorfer, K. Hasselbach, A. Benoit, B. Barbara, D. Mailly, J. Tuaillon, J. P. Perez, V. Dupuis, J. P. Dupin, G. Guiraud, and A. Perex, p 7192, Journal of Applied Physics, volume 78, (1995).

However, a drawback of the prior art microSQUIDs is that they require micro-fabricated coils to generate magnetic fields to tune them. Moreover, coils can only be used to generate flux to provide an offset flux..

This drawback may be addressed by a dc SQUID utilizing two Dayem bridge weak-link Josephson junctions which are controlled via irradiation of hot phonons from nearby titanium/chromium normal metal constrictions and further details of the device can be found in "Hot phonon controlled junctions superconducting quantum interference device" by G. D. Hutchinson, H. Qin, S. B. Lee, D. G. Hasko, M. G. Blamire and D. A. Williams, Semiconductor Science and Technology, page 1544, volume 16 (2003).

The present invention also seeks to provide apparatus including at least one SQUID.

According to a first aspect of the present invention there is provided apparatus comprising a superconducting quantum interference device (SQUID) having first and second Josephson junctions and first and second phonon generators configured to control charge carrier transport through said first and second Josephson junctions respectively; and a device, inductively or electrostatically coupled to the SQUID, for measuring a state of the SQUID. This can have the advantage that the SQUID can provide a qubit for quantum computing. Furthermore, the SQUID can be coupled to an amplifier so as to provide a more sensitive magnetic field detector. Moreover, the SQUID can be incorporated more easily into circuits.

The apparatus may be for quantum computing. Thus, the SQUID may provide a qubit which, due to not being resistively coupled to a measuring device, is in a quiet electromagnetic environment and, thus, can maintain coherence for longer.

The SQUID and the measuring device may be disposed on a substrate

The measuring device may be a SQUID. Alternatively, the measuring device may be a single charge transistor (SCT). Using an SC can have the advantage that it may be easier to interface the apparatus into other types of devices. The SQUID may comprise an island of superconducting material disposed between the first and second Josephson junctions, the island and the junctions arranged such that the charging energy of the island is larger than the superconducting gap of superconducting material. The SQUID may comprise an island disposed between the first and second Josephson junctions, the island having dimensions smaller than 50 nm.

The apparatus may further comprise a gate for controlling the state of the SQUID. The gate may comprise a microwave source, which may include a microwave emitter arranged sufficiently close to irradiate the SQUID with microwaves.

The apparatus may comprise at least one additional SQUID coupled to the SQUID. The apparatus may comprise at least two additional SQUIDs, one of the additional SQUIDs coupled to the SQUID. The apparatus may comprise a further device, coupled to the additional SQUID or one of the additional SQUIDs, for measuring a state of said the or said one of the additional SQUIDs. The SQUID and the additional SQUID or one of the additional SQUIDs may overlap. This can help build devices having larger numbers of qubits.

According to a second aspect of the present invention there is provided a method of operating apparatus comprising a superconducting quantum interference device (SQUID) having first and second Josephson junctions and first and second phonon generators configured to control charge carrier transport through said first and second Josephson junctions respectively; and a device, inductively or electrostatically coupled to the SQUID, for measuring a state of the SQUID, the method comprising causing generation of phonons so as to set the SQUID in an initial state; and, thereafter, measuring a final state of the SQUID.

The first and second phonon generators may comprise constrictions in a normal conducting channel and causing generation of phonons may comprise causing current to flow through said channel.

The apparatus may further comprise a gate for controlling the state of the SQUID and the method may further comprise manipulating the initial state of the SQUID. The gate may comprise a microwave source and manipulating the initial state of the SQUID comprises applying a microwave pulse to the SQUID.

According to a third aspect of the present invention there is provided a method of operating apparatus comprising a superconducting quantum interference device (SQUID) having first and second Josephson junctions and first and second phonon generators configured to control charge carrier transport through said first and second Josephson junctions respectively; and a device, inductively or electrostatically coupled to the SQUID, for measuring a state of the SQUID, the method comprising causing generation of phonons so as to tune the SQUID and measuring current flow through the SQUID using said measuring device.

According to a fourth aspect of the present invention there is provided a method of fabricating apparatus, the method comprising providing a superconducting quantum interference device (SQUID) having first and second Josephson junctions and first and second phonon generators configured to control charge carrier transport through said first and second Josephson junctions respectively and providing a device, inductively or electrostatically coupled to the SQUID, for measuring a state of the SQUID.

The method may comprise arranging the SQUID and the measuring device on a substrate.

Embodiments of the present invention will now be described, by way of example, with reference to the accompanying drawings in which:

Figure 1 is a perspective view of an embodiment of a SQUID;
Figure 2 is a plan view of the SQUID shown in Figure 1;
Figure 3 is a cross-sectional view of the SQUID shown in Figure 1;
Figure 4 shows a circuit for measuring the SQUID shown in Figure 1;
Figure 5 show current-voltage curves for the SQUID shown in Figure 1 at 4.2 °K;
Figure 6 shows magnetic flux passing through the SQUID shown in Figure 1;
Figure 7 shows plots of critical current against magnetic field for the SQUID shown in Figure 1 with different heater currents;
Figures 8a to 8i are cross sectional views of the SQUID at different stages during fabrication;
Figures 9a to 9i are plan views of the SQUID at different stages during fabrication;
Figure 10 is a circuit diagram of an embodiment of system for measuring magnetic field in accordance with an aspect of the present invention;
Figure 11 is a plan view of the system shown in Figure 10;
Figures 12 and 13 are cross-sectional views of the system shown in Figure 11;
Figure 14 shows a response of the system shown in Figure 10;
Figure 15 is a circuit diagram of embodiment of quantum computer system in accordance with an aspect of the present invention;
Figure 16 is a plan view of the system shown in Figure 15;
Figure 17 is a cross-sectional view of the system shown in Figure 16;
Figure 18 is a circuit diagram of another embodiment of quantum computer system in accordance with an aspect of the present invention;
Figure 19 is a plan view of the system shown in Figure 18;
Figure 20 is a cross-sectional view of the system shown in Figure 19;
Figure 21a to 21g are plan views of the system shown in Figure 19 at different stages during fabrication;

Figure 22 illustrates a gating arrangement for the system shown in Figure 19;

Figure 23 is a is a plan view of a further embodiment of quantum computer system in accordance with an aspect of the present invention;

Figures 24 and 25 are cross-sectional view of the device shown in Figure 23; and

Figure 26 is a circuit diagram of further embodiment of quantum computer system in accordance with an aspect of the present invention.

SQUID 1

*Device layout*

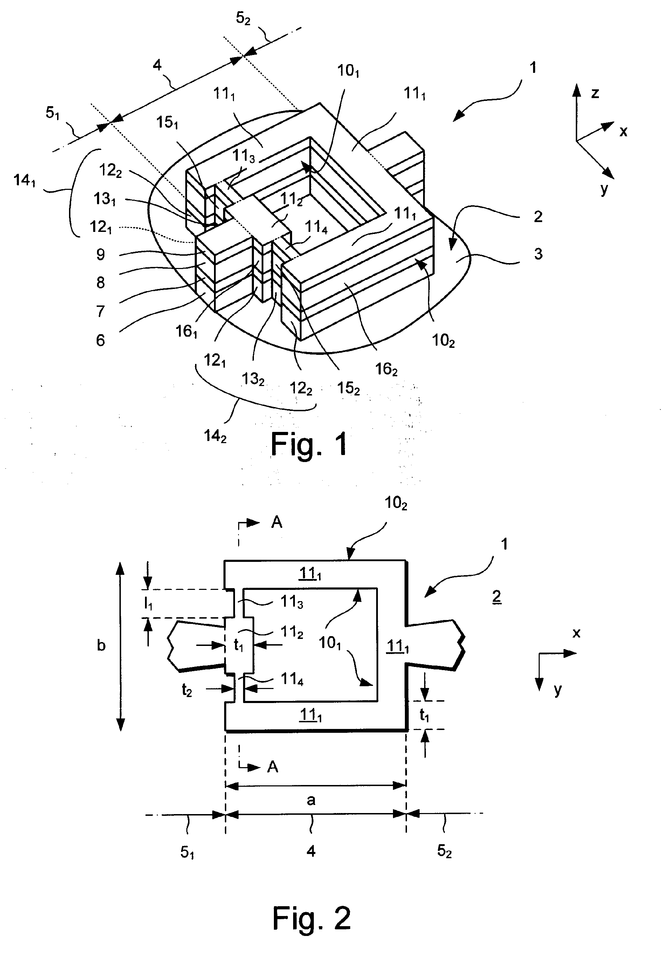

Referring to Figures 1, 2 and 3, a SQUID 1 is formed on a top surface 2 of a substrate 3. The substrate 3 comprises oxidised silicon. The SQUID 1 comprises an upstanding structure $4, 5_1, 5_2$ comprising a plurality of overlying patterned layers 6, 7, 8, 9. The upstanding structure $4, 5_1, 5_2$ includes a ring portion 4, and first and second arm portions $5_1, 5_2$ extending laterally from the ring portion 4.

The patterned layers 6, 7, 8, 9 are substantially co-extensive. Thus, inner and outer sidewalls $10_1, 10_2$ defining the upstanding structure $4, 5_1, 5_2$ are substantially vertical. However, the sidewalls $10_1, 10_2$ may slope so as to form a structure which is narrower at its base than at its top or *vice versa.*

The ring portion 4 forms a walled enclosure, which is generally hollowly rectangular in plan view, and comprises four sections $11_1, 11_2, 11_3, 11_4$. A first section $11_1$ comprises three walls of the enclosure. A second section $11_2$ provides a central part of a fourth wall. The third and fourth sections $11_3, 11_4$ connect the ends of the second section $11_2$ to the ends of the first section together and complete the walled enclosure. The walls in the first and second sections $11_1, 11_2$ are relatively thick and the walls in the third and fourth sections $11_3, 11_4$ are relatively thin. Thus, the third and fourth sections provide constrictions in the layers 6, 7, 8, 9.

The ring portion 4 can be differently configured. For example, it can be generally hollowly elliptical or hollowly circular (i.e. annular) in plan view.

A first layer 6 comprises a superconducting material, in this example niobium (Nb), and has a thickness of 50 nm. The first layer 6 overlies the top surface 2 of the substrate 3 and comprises first and second superconducting regions $12_1, 12_2$ and first and second non-superconducting regions $13_1, 13_2$. The superconducting and non-superconducting regions $12_1, 12_2, 13_1, 13_2$ are arranged so as to form first and second Josephson junctions $14_1, 14_2$.

The Josephson junctions $14_1, 14_2$ are in the form of Dayem bridge weak-link Josephson junctions. Thus, the superconducting and non-superconducting regions $12_1, 12_2, 13_1, 13_2$ comprise the same superconducting material. However, the width of superconducting material in the non-superconducting regions $13_1, 13_2$ is narrower than the width of superconducting material in the superconducting regions $12_1, 12_2$ and arranged such that these regions do not exhibit superconductivity but form weak links.

Superconducting materials other than Nb may be used, such as other metallic superconductors, for instance tin (Sn). So-called "high-Tc" superconductors, for example $YBa_2Cu_3O_7$ may be used. The layer 6 may comprise more than one superconducting material. For example two or more overlying layers, each comprising a different superconducting material, may be used. Alternatively, the first superconducting region may comprise a first superconducting material and the second superconducting region may comprise a second, different superconducting material. The dimensions and configurations needed to form a Dayem bridge in a layer of superconducting material can be found by routine experiment.

Josephson junctions other than Dayem bridges may be used, such as Notary bridges, point contact junctions and cross wire weak links. Josephson junctions formed over steps or edges may also be used. The dimensions and configurations needed to form weak links can be found by routine experiment.

This thickness of the first layer 6 may be between 1 and 100 nm. Preferably, the thickness of the first layer 6 is less than 50 nm. Additionally or alternatively, the thickness of the first layer 6 may vary across the layer. For example, the first layer 6 may be thinned in the region of the bridge so as to provide current concentration.

A second layer 7 comprises an electrically insulating material, in this example silicon dioxide ($SiO_2$), and has a thickness of 30 nm. The second layer 7 overlies the first layer 6 and electrically insulates the first layer 6 from a layer 8 above it.

Electrically insulating materials other than $SiO_2$ may be used, such as $Si_xN_y$. The minimum thickness needed to provide insulation may be found by routine experiment. The choice of material may depend on one or more processes used to fabricate the SQUID 1.

A third layer 8 comprises an electrically conducting normal material, such as titanium (Ti), and has a thickness of 50 nm. The third layer 8 overlies the second layer 7 and includes first and second constrictions $15_1, 15_2$ and connecting regions $16_1, 16_2$. The width of the conductive material in the constrictions $15_1, 15_2$ is narrower than the width of the material in the connecting regions $16_1, 16_2$. Thus, when a current is passed through the third layer 8 between the first and second arm portions $5_1$, $5_2$, the current density in the constrictions $15_1$, $15_2$ is greater than in the connecting regions $16_1$, $16_2$ and so can be used to generate hot phonons locally in the region of the Josephson junctions $14_1$, $14_2$. Thus, the constrictions $15_1$, $15_2$ may also be referred to as "hot phonon generators" or "heaters".

Conductive materials other than Ti can be used. Preferably, the conductive material is non-magnetic. Furthermore, the thicknesses needed to provide heating in one region, but not another may be found by routine experiment.

A fourth layer 9 comprises chromium (Cr) and has a thickness of 30 nm. The fourth layer 9 is used as a mask to form the other patterned layers 6, 7, 8 and may be removed after these layers 6, 7, 8 have been formed. If electrically conductive, the fourth layer 9 may co-operate with the third layer 8 to provide the hot phonon generators $15_1$, $15_2$ and the connecting regions $16_1$, $16_2$. If the conductive layer 8 can provide a mask, then the fourth layer 9 may be omitted.

Referring in particular to Figure 2, the ring portion 4 has a length of 1.3 $\mu$m and a width 1.45 $\mu$m as indicated by arrows a and b respectively. The first and second sections $11_1$, $11_2$ have lateral thicknesses (width) of 280 nm as indicated by arrows $t_1$. The third and fourth sections $11_3$, $11_4$ each have a lateral thickness (width) of 100 nm as indicated by arrow $t_2$ and length of 200 nm as indicated by arrow $1_1$.

The non-superconducting regions $13_1$, $13_2$ in first layer 6 and the hot phonon generator $15_1$, $15_2$ in the third layer 8 are 100 nm wide and 200 nm long. As explained earlier, the constrictions provided by the third and fourth sections $11_3$, $11_4$, result in a weak-links in the Nb layer 6 and form constrictions $15_1$, $15_2$ in the Ti layer 8 which provide hot phonon generators.

Thus, the SQUID 1 includes two Josephson junction $14_1$, $14_2$ and respective phonon generators $15_1$, $15_2$ associated with each junction $14_1$, $14_2$ for controlling charge carrier transport through the junctions $14_1$, $14_2$. In particular, the critical currents of the two Josephson junctions $14_1$, $14_2$ are controlled by irradiation with hot phonons generated by generators $15_1$, $15_2$.

Further details can be found in "Hot phonon controlled junctions superconducting quantum interference device" *ibid..*

*Device characteristics*

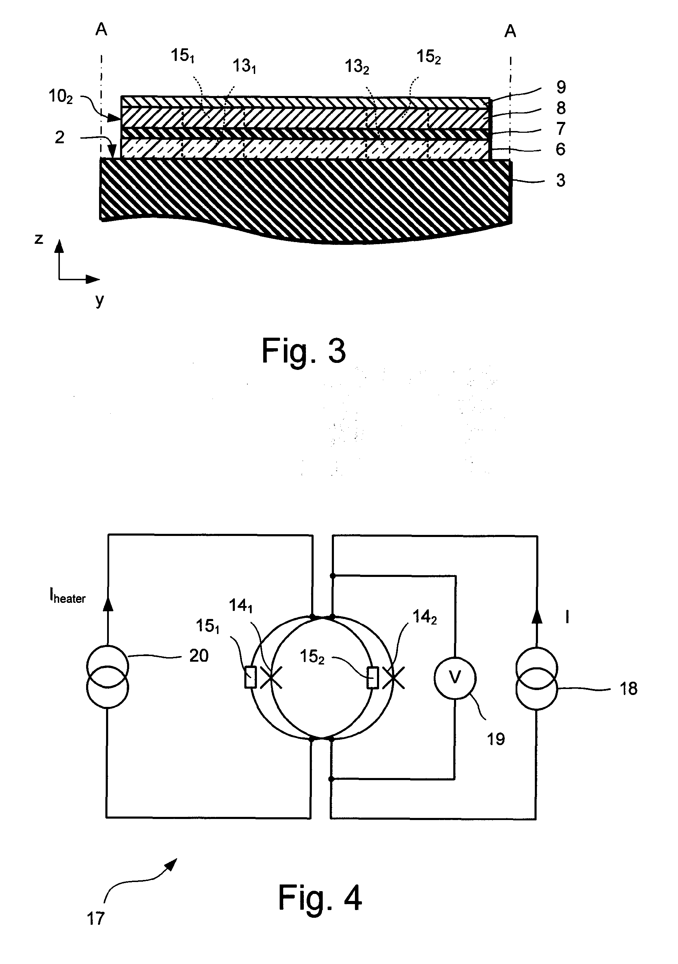

Referring to Figure 4, a circuit 17 for controlling and measuring the SQUID 1 includes a current source 18 for passing a current bias I through the Nb layer 6, a voltage meter 19 for measuring the voltage drop V across the Nb layer 6 and a current source 20 for passing a current bias $I_{beater}$ through the Ti layer 8.

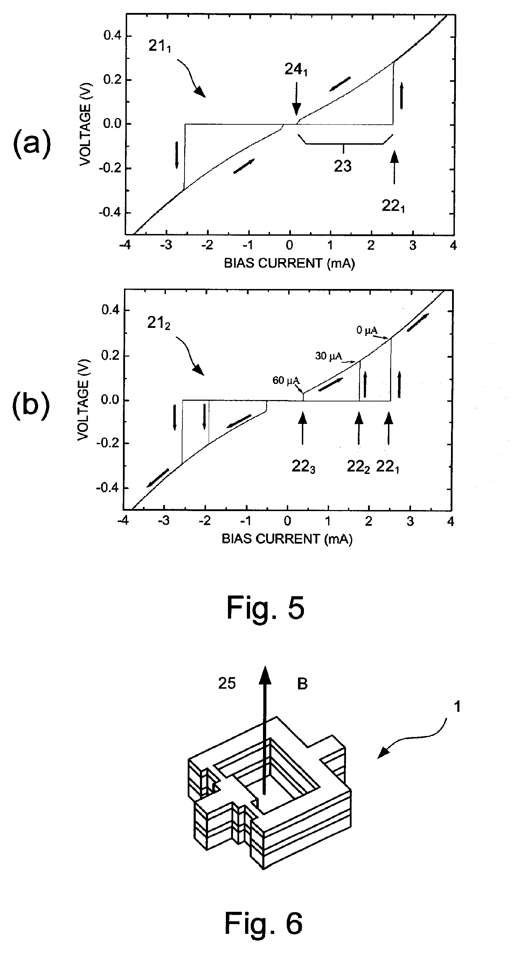

Referring to Figures 5a and 5b, first and second current-voltage curves $21_1$, $21_2$ are shown for the SQUID 1 measured in liquid helium at a temperature of 4.2 °K.

The SQUID 1 and other similarly fabricated SQUIDs (not shown) have critical currents $I_c$ between 2.4 and 2.6 mA.

Referring to Figure 5a, the SQUID 1 is able to carry large currents before switching to a normal state at transition point $22_1$. Thus, a large thermal hysteresis effect 23 is observed in the current-voltage curve $21_1$. The SQUID 1 switches back to a superconducting state below 200 $\mu$A at transition point $24_1$. The hysteresis effect 23 in the current-voltage curve $21_1$ is caused by heat generated by the Dayem bridges $13_1$, $13_2$ (Figure 1) when the device switches to a voltage state, i.e. non-superconducting state. For this reason the SQUID 1 uses a current ramp scheme to probe the critical current relative to the applied flux for magnetic readout.

Referring to Figure 5b, applying a bias current $I_{beater}$ to the Ti layer 8 (Figure 1) causes the critical current of the SQUID 1 to be suppressed. For example, the SQUID 1 switches to a normal state at transition point $22_2$ for a heater current 30 $\mu$A and at transition point $22_3$ for a heater current 60$\mu$A. For a heater current above 70 $\mu$A, the critical current of the SQUID 1 is completely suppressed. The heater current $I_{beater}$ influences the magnitude of the current I passing through the Nb layer 6 at which the transition from the superconducting state to the voltage state takes place. The remaining characteristics follow the same hysteresis cycle.

Referring to Figure 6, a magnetic field source (not shown), such as a coil, is used to apply a magnetic field 25 to the SQUID 1. The SQUID 1 is measured by running bias current sweeps and measuring the voltage in conjunction with sweeping the applied magnetic field to the SQUID 1.

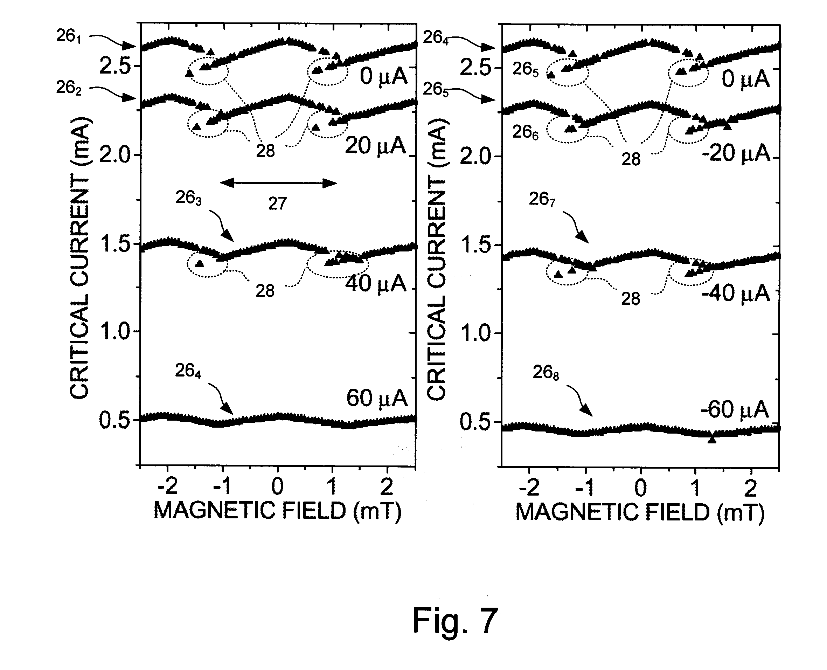

Referring to Figure 7, plots $26_1$, $26_2$, $26_3$, $26_4$, $26_5$, $26_6$, 26y, $26_8$ of critical current against applied magnetic field B for different heater currents are shown.

An oscillation 27 in critical current was observed having a period of 2.1 mT. The observed triangular shape of the oscillation 27 is a result of the size of the "long" Josephson junctions $14_1$, $14_2$ (Figure 1) because their effective lengths are around $5\xi_0$, where $\xi_0$ is about 39 nm and is the coherence length of Cooper pairs in niobium thin films. This means that the long Josephson junction deviates from the ideal Josephson supercurrent-phase relationship $I_c = I_0 \sin\phi$.

Unstable points 28 at the minima in the critical current oscillations are also due to the high critical current. For large critical currents, such that $2LI_c > \Phi_0$, more than one inductance-induced screening current state can be set up in the SQUID 1 for a particular applied magnetic flux. From the dimensions of the SQUID 1, a geometrical inductance around 1.4 pH is expected and so for a critical current above 0.8 mA magnetic hysteresis is expected. In the high heater current region, above 60 $\mu$A, where the critical current is below 0.5 mA, a magnetic hysteresis can be seen in the oscillations. The onset of magnetic hysteresis suppression is lower than expected, based on the geometrical inductance of the SQUID 1. This may be due to a significant self-inductance contribution from the Josephson junctions. Using the relation $\Delta I_c/I_c = 1/(1+\beta)$ where $\beta = 2\pi\, LI_c/\Phi_0$, the inductance of the SQUID 1 can be estimated to be about 3pH.

By providing Dayem-bridge Josephson junctions $14_1$, $14_2$ that have electrically isolated, close-proximity normal metal constrictions 151, $15_2$, the critical current in the SQUID 1 can be controlled. Applying a bias current $I_{heater}$ through the Ti layer 8 results in the Josephson junctions $14_1$, $14_2$ being irradiated by hot phonons (not shown). The magnitude of the critical current $I_c$ is controlled by these hot phonons (not shown), which are emitted by electrons (not shown) in the Ti layer 8, heated by the current concentration in the constrictions $15_1$, $15_2$. In addition, the position of the minima in the critical current oscillations also changes.

The electron and phonon mean free paths (not shown) are much smaller than the dimensions of the SQUID 1. However, these mean free paths are not smaller than the separation of a constriction $15_1$, $15_2$ and a respective Josephson junction $14_1$, $14_2$. Transport along the device 1 is diffusive. Thus, an electron "hot spot" is created in the middle section of the constriction $15_1$, $15_2$. The electron hot spot emits phonons (not shown) with a characteristic energy that is much larger than that characteristic of the lattice temperature. The hot phonons (not shown) degrade rapidly through phonon-phonon interactions and are thermalised. However, they are able to travel the short distance from the constriction $15_1$, $15_2$ into the Nb layer 6 before this process is complete. These hot phonons (not shown) are very effective in suppressing the superconductivity in the weak link $14_1$, $14_2$ by breaking up Cooper pairs (not shown). Only phonons (not shown) with energies greater than $2\Delta$ (where $\Delta$ is the superconducting gap energy), which would normally be absent at temperatures below $T_c$, are important in the control mechanism of the device.

### *Fabrication*

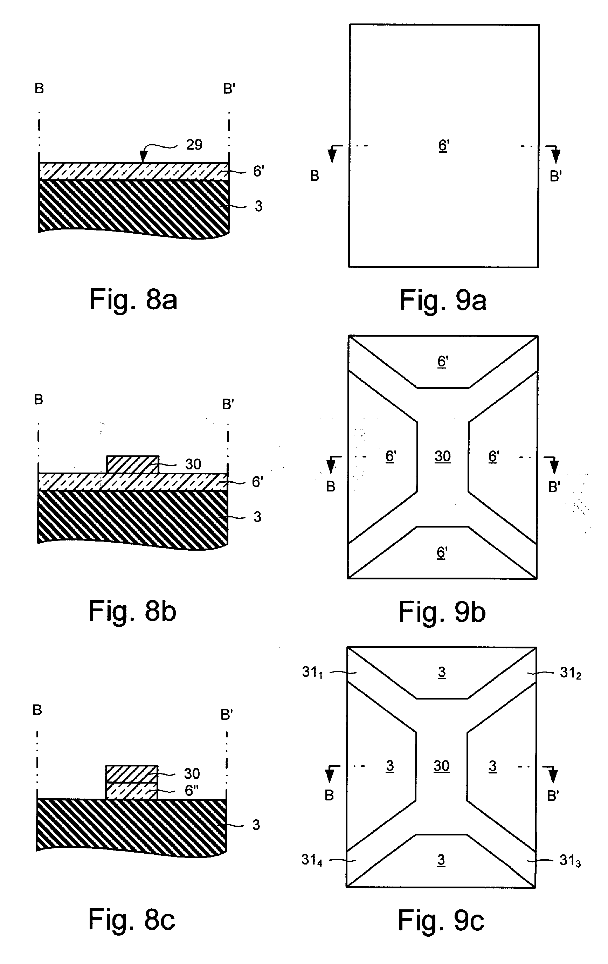

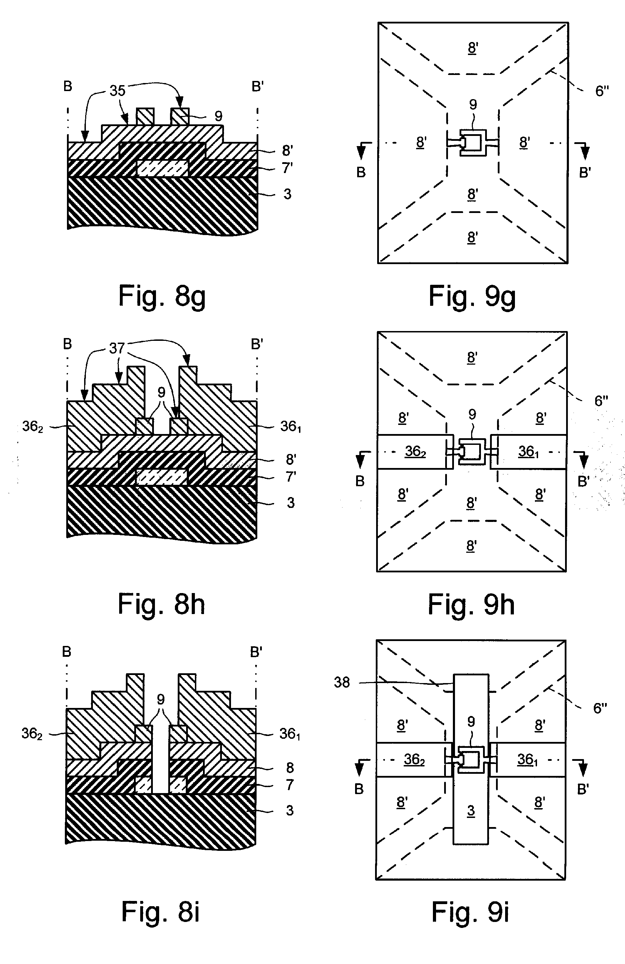

Referring to Figures 8a to 8i and 9a to 9i, a method of fabricating the SQUID 1 is shown.

A niobium (Nb) film 6' having a thickness of 50 nm is sputtered in an ultra-high vacuum (UHV) system onto an oxidized silicon substrate 3. The corresponding layer structure is shown in Figure 8a.

A first electron lithography step is carried out. A layer of polymethylmethacrylate (PMMA) (not shown) is applied to a top surface 29 of the Nb film 6', selectively exposed by an electron beam (not shown) using an electron beam lithography system (not shown) and developed with an methyl isobutyl keytone (MIBK) diluted with isopropanol alcohol (IPA).

An aluminium layer (not shown) having thickness of 30 nm is thermally evaporated onto the developed PMMA layer (not shown) and lifted-off in acetone to leave an aluminium etch mask 30. The corresponding layer structure is shown in Figure 8b.

The pattern of the aluminium etch mask 30 is transferred to the underlying Nb film 6' using reactive ion etching with a mixture of carbon tetrafluoride ($CF_4$), oxygen ($O_2$) and silicon tetrachloride ($SiCl_4$) gases in proportion 65%, 10% and 25% respectively (by volume), thus leaving a patterned Nb film 6". The corresponding layer structure is shown in Figure 8c. The etch also defines electrical leads $31_1$, $32_2$, $31_3$, $31_4$ in the patterned Nb film 6".

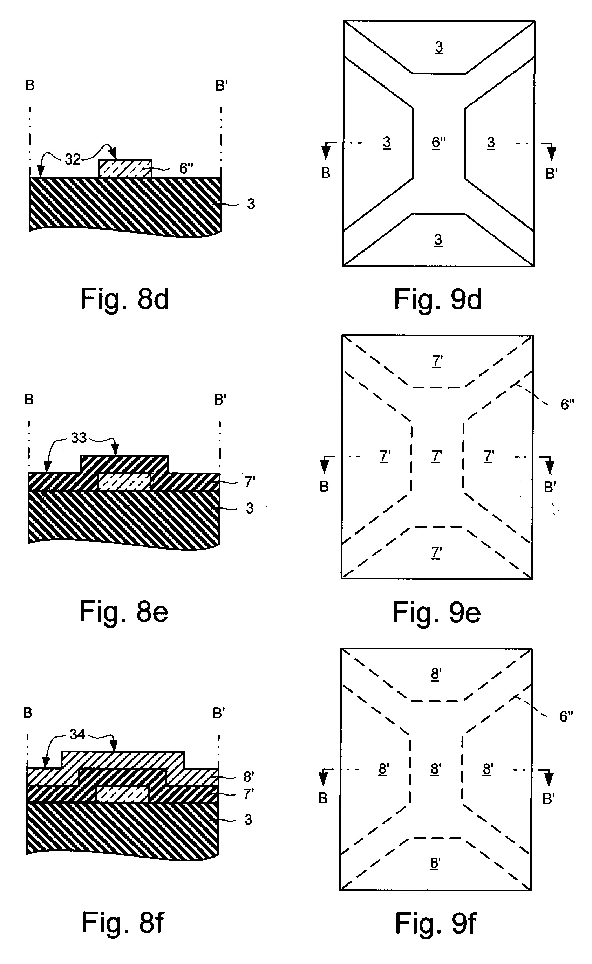

The aluminium etch mask 30 is removed using an aluminium wet etch (not shown) comprising a mixture of acetic, nitric and phosphoric acid, and water. The corresponding layer structure is shown in Figure 8d.

A silicon dioxide ($SiO_2$) layer 7' having a thickness of 30 nm is sputtered over an exposed surface 32 of the patterned Nb film 6" and substrate 3. This thickness of the $SiO_2$ layer 7' was found to be thin enough to provide sufficient phonon irradiation and yet thick enough to avoid pin-hopes and provide electrical isolation. The corresponding layer structure is shown in Figure 8e.

A titanium (Ti) film 8' having a thickness of 50 nm is sputtered over a top surface 33 of the $SiO_2$ layer 7'. Ti was chosen because it has a lower etch rate than Nb during RIE. The corresponding layer structure is shown in Figure 8f.

A second electron lithography step is carried out. A layer of PMMA (not shown) is applied to a top surface 33 of the Ti film 8', selectively exposed by an electron beam (not shown) using a high resolution electron beam lithography system (not shown) and developed with MIBK/IPA.

A chromium (Cr) film (not shown) having thickness of 30 nm is thermally evaporated onto the developed PMMA layer (not shown) and lifted-off in acetone to leave the Cr etch mask layer 9. The corresponding layer structure is shown in Figure 8g.

Although slightly magnetic, chromium was used as a material because it provided a superior edge profile compared to some other materials. For example, if aluminium (Al) is used as an etch mask, edge definition is poor due to re-sputtering of Al during etching.

A third electron lithography step is carried out. A layer of PMMA (not shown) is applied to a top surface 35 of the Ti film 8' and Cr etch mask 8, selectively exposed by an electron beam (not shown) using an electron beam lithography system (not shown) and developed with MIBK/IPA.

An Al film (not shown) having a thickness of 300 nm is sputtered onto the developed PMMA layer (not shown) and lifted-off in acetone to leave the aluminium connections $36_1$, $36_2$ to the Cr and Ti films 7, 8'. The corresponding layer structure is shown in Figure 8h.

A fourth electron lithography step is carried out. A layer of PMMA (not shown) is applied to a top surface 36 of the Ti film 8', Cr etch mask 8 and Al connections $36_1$, $36_2$, selectively exposed by an electron beam (not shown) using an electron beam lithography system (not shown) and developed with MIBK/IPA.

A window (not shown) in the PMMA layer (not shown) is thus opened between aluminium connections $36_1$, $36_2$. The PMMA layer (not shown) is used as an etch mask to protect Nb connections $31_1$, $31_2$, $31_3$, $31_4$.

The pattern of the Cr etch mask 9 is transferred to the underlying Ti, $SiO_2$ and Nb layers 6", 7', 8' using RIE with a mixture of $CF_4$ and $O_2$ in proportion 90% and 10% respectively (by volume), thus forming SQUID 1 in a trench 37. Another dry etch may be used. The corresponding layer structure is shown in Figure 8i.

Using Ti, $SiO_2$ and Nb has the advantage that the layers 6", 7', 8' can be successively etched using the same dry etch. Other materials can be used which can each be etched using the same dry etch. However, other materials can be used which are etched using at least two different dry etches. Additionally or alternatively, wet etches may be used.

This process has an advantage that the Josephson junctions $14_1$, $14_2$ and constrictions $15_1$, $15_2$ are self-aligned.

It will be appreciated that further process steps may be included, such as to provide vias (not shown) to connections $31_1$, $31_2$, $31_3$, $31_4$ and/or to define chromium/gold (Cr/Au) bond pads (not shown).

The SQUID 1 or SQUIDs substantially similar to the SQUID 1 hereinbefore described can be used in a number of circuits and systems in accordance with the present invention, as will now be described in more detail:

**Magnetic field detector 39**

*Device layout*

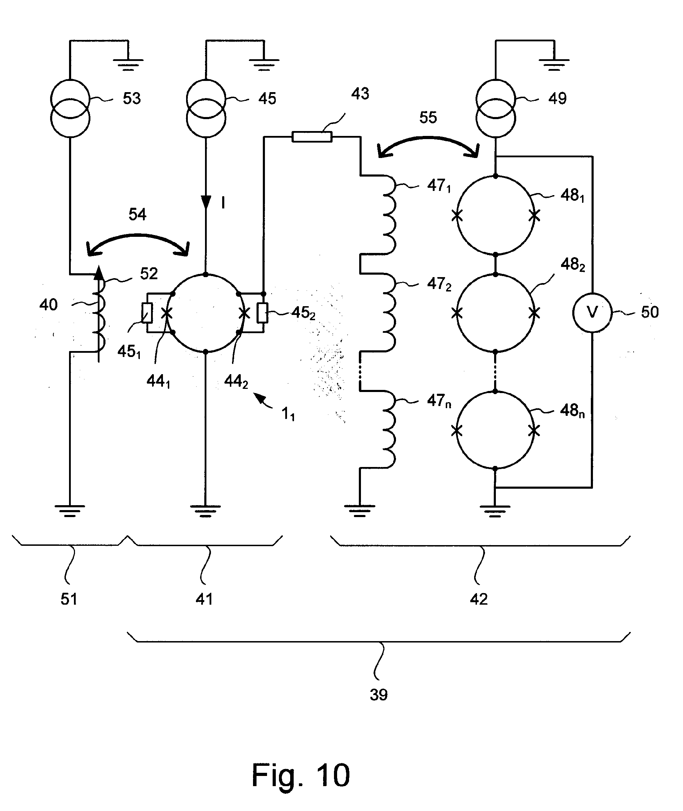

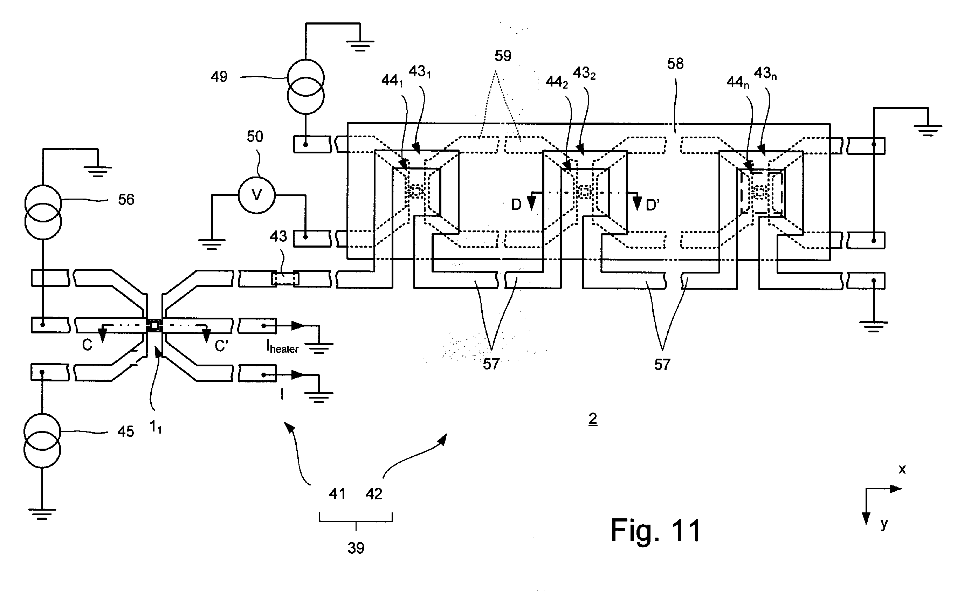

Referring to Figures 10 and 11, a circuit 39 for sensing a magnetic field 40 is shown. The circuit 39 can be included in a magnetic resonance imaging (MRI) system (not shown).

The circuit 39 includes a SQUID sensor 41 having a SQUID $1_1$ and a SQUID amplifier 42 coupled to the SQUID $1_1$ by a load resistor 43

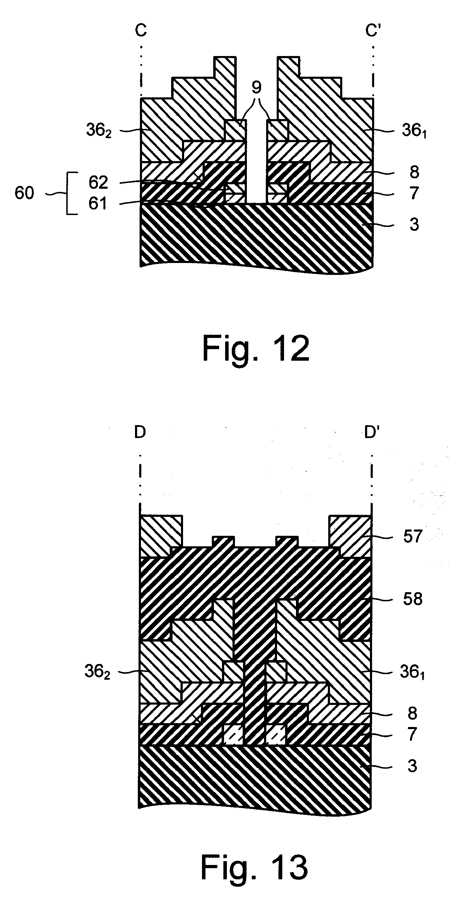

As will be explained in more detail later, the SQUID $1_1$ is similar to the SQUID 1 described earlier, but includes a normal/superconducting bi-layer 60 (Figure 12) instead of superconducting layer 6 (Figure 1). Thus, SQUID $1_1$ includes Josephson junctions $44_1$, $44_2$ having respective shunt resistors $45_1$, $45_2$. Unless otherwise stated, the same reference numerals are used to describe SQUID $1_1$ as SQUID 1 (Figure 1).

The SQUID sensor 41 includes a current source 46 for driving a current through the SQUID $1_1$.

The SQUID amplifier 42 includes a plurality of load inductors $47_1$, $47_2$, $47_n$ arranged in series and a plurality of SQUIDs $48_1$, $48_2$, $48_n$ also arranged in series. The load inductors $47_1$, $47_2$, $47_n$ are arranged to couple inductively to corresponding SQUIDs $48_1$, $48_2$, $48_n$.

As will be described in more detail later, each SQUID $48_1$, $48_2$, $48_n$ is substantially the same as the SQUID 1 described earlier. However, conventional SQUIDs may be used.

The SQUID amplifier 42 includes a current source 49 for driving a current bias I through SQUIDs $48_1$, $48_2$, $48_n$ and a voltage sensor 50 for sensing the voltage drop across SQUIDs $48_1$, $48_2$, $48_n$.

The magnetic field 40 may be generated by a source 51. For example, the source 51 may a coil 52 having a current source 53.

Thus, the circuit 39 can be used as a magnetic sensor by virtue of flux coupling 54 between the source 51 and SQUID sensor 41 and flux coupling 55 between the SQUID sensor 41 and the SQUID amplifier 42.

Referring in particular to Figure 11, the circuit 39 also includes a current source 56 for driving a heater current $I_{heater}$ through Ti layer 8 (Figure 1). This allows tuning of coupling 54 and provides control over sensitivity. The current source 56 and heaters $15_1$, $15_2$ (Figure 2) are not shown in Figure 10 for clarity.

The load inductors $47_1$, $47_2$, $47_n$ are in the form of loops disposed over the SQUIDs $48_1$, $48_2$, $48_n$ and provided by a track 57 running over an insulating layer 58. The track 57 comprises a bi-layer of titanium and gold having thicknesses of 20 and 200 nm respectively. The insulating layer 58 comprises silicon dioxide ($SiO_2$) and has a thickness of 200 nm.

The SQUIDs $48_1$, $48_2$, $48_n$ are connected by tracks 59. The tracks 59 comprise niobium and are formed at the same time as SQUIDs $48_1$, $48_2$, $48_n$.

Referring to Figure 12, the SQUID $1_1$ is similar to the SQUID 1 shown in Figure 1, but includes a normal/superconducting bi-layer 60 instead of a superconducting layer 6. The bi-layer 60 comprises a layer 61 of niobium and a layer 62 of gold. The gold layer 62 provides shunt resistors $45_1$, $45_2$ (Figure 10) and heat sinks to avoid self-heating (i.e. Joule heating) if the superconducting layer 61 switches to a voltage state. The shunt resistors $45_1$, $45_2$ (Figure 10) each have a value of about $2\Omega$.

The niobium and gold layers 61, 62 each have a thickness of 25 nm. However, the layers 61, 62 need not share the same thickness. The thicknesses of the niobium and layers 61, 62 may be between 1 and 100 nm and can be found by routine experiment. For example, the thickness of the niobium layer 61 may be reduced until there is an increase (for example, more than 10%) in critical temperature $T_c$ and the thickness of the gold layer 61 may be reduced until hysteretic behaviour is observed.

As explained earlier, other superconducting materials can be used instead of niobium. Furthermore, other normal conducting materials may be used instead of gold.

Referring to Figure 13, the SQUIDs $48_1$, $48_2$, $48_n$ are substantially the same as the SQUID 1 described earlier. Each SQUIDs $48_1$, $48_2$, $48_n$ may be provided with a respective current source (not shown) so as to heat Ti layer 8. Thus, each SQUID $48_1$, $48_2$, $48_n$ can be individually tuned so as to maximise sensitivity.

The SQUIDs $48_1$, $48_2$, $48_n$ may be modified to include a normal/superconducting bi-layer (not shown) instead of a superconducting layer 6, similar to SQUID $1_1$. This can facilitate manufacture since the bi-layer (not shown) for SQUID $1_1$ and SQUIDs $48_1$, $48_2$, $48_n$ can be defined at the same time.

Alternatively, conventional SQUIDs, for example without any Ti heater layer 8, may be used.

As explained earlier, the SQUIDs $48_1$, $48_2$, $48_n$ are electrically isolated from the track 57 providing loops by an insulating layer 58. The insulating layer 58 may be deposited conformally, for example by sputtering or chemical vapour deposition, may provide at least partial planarisation and fill voids, as shown in Figure 13.

*Operation*

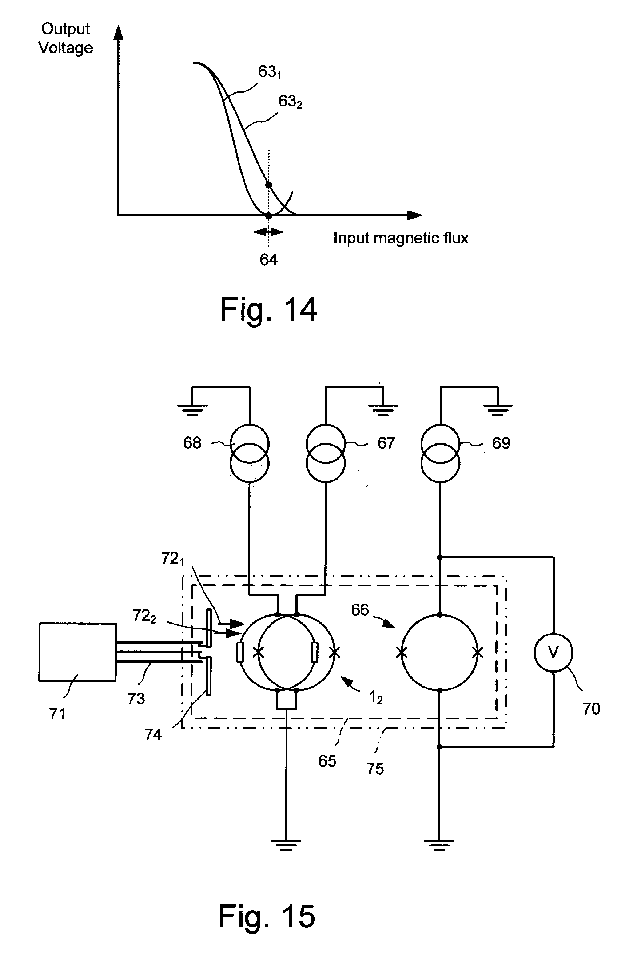

Referring to Figure 14, responses $63_1$, $63_2$ of the SQUID $1_1$ at different heater currents are shown.

At a first heater current, i.e. $I_{heater} = I_1$, the SQUID $1_1$ exhibits a first response $63_1$, as measured by voltage sensor 50 (Figures 10 & 11). If the magnetic flux varies around a given value 64 which happens to coincide with a local minimum in the response $63_1$, then the output voltage will vary only slightly.

At a second heater current, i.e. $I_{heater} = I_2 \neq I_1$, the SQUID $1_1$ exhibits a second response $63_2$ in which the minimum is shifted to a different value of flux. Thus, if the magnetic flux varies around the given value 64, then the output voltage will vary, for example by a greater amount.

For a given value of magnetic flux, the heater current can be varied to find a response having maximum gradient.

Thus, using the heaters $15_1$, $15_2$ (Figure 2) allows sensitivity of the SQIUD $1_1$ to be controlled

**Flux single-qubit device 65**

*Device layout*

Referring to Figures 15, 16 and 17, a system is shown which includes a first embodiment of a device 65 for quantum computing in accordance with the present invention.

The device 65 includes a SQUID $1_2$ for providing a flux qubit and a SQUID (hereinafter referred to as an "exit SQUID") 66 for measuring the state of the SQUID $1_2$.

The SQUID $1_2$ is substantially the same as the SQUID 1 described earlier and fabricated in substantially the same way. Thus, where appropriate, the same reference numerals are used. A current source 67 is arranged to drive a current bias I through the Nb layer 6 and a current source is provided to pass a current bias $I_{heater}$ through the Ti layer 8.

The exit SQUID 66 is substantially the same as the SQUID 1 described earlier and fabricated in substantially the same way. However, conventional SQUIDs may be used. A current source 69 is provided for applying a current bias I through the Nb layer 6 or other superconducting layer (not shown) of the exit SQUID 68 and a voltage meter 70 is provided for measuring the voltage drop V

A signal generator 71 is used for providing microwave pulses $72_1$, $72_2$ for qubit manipulation. The signal generator 71 is connected via a semi-rigid co-axial cable 73 to a Hertzian dipole antenna 74. Other signal generators, waveguides and emitters may be used. For example, a Gunn diode may be used. A Horn antenna may be used as an emitter.

The device 65 is placed in a system 75 for cooling the device to sub-4.2 K temperatures. In this example, the system 75 is a dilution refrigerator. However, other cooling systems may be used, such as continuous flow cryostats. The single-qubit device 65 is based on a flux qubit. Basis states can be defined as:

$$|0\rangle \equiv |\text{clockwise}\rangle$$

$$|1\rangle \equiv |\text{anti-clockwise}\rangle$$

where clockwise and anti-clockwise refer to directions of current flow through in the Nb layer 6 in the ring portion 4 of SQUID $1_2$ as viewed from above. It will be appreciated that the basis states can be defined in terms of flux direction, for example $|up\rangle$ and $|down\rangle$. More complex basis states can be defined. For example, a more complex set of basis states can be defined in terms of a superposition of $|0\rangle$ and $|1\rangle$, such as:

$$|0'\rangle = 2^{-\frac{1}{2}}(|0\rangle + |1\rangle)$$

$$|1'\rangle = 2^{-\frac{1}{2}}(|0\rangle - |1\rangle)$$

When the SQUID $1_2$ is sufficiently cooled, for example to 20 mK, a qubit may be prepared as a superposition of quantum states. The quantum states remain coherent long enough so as to permit manipulation of the qubit.

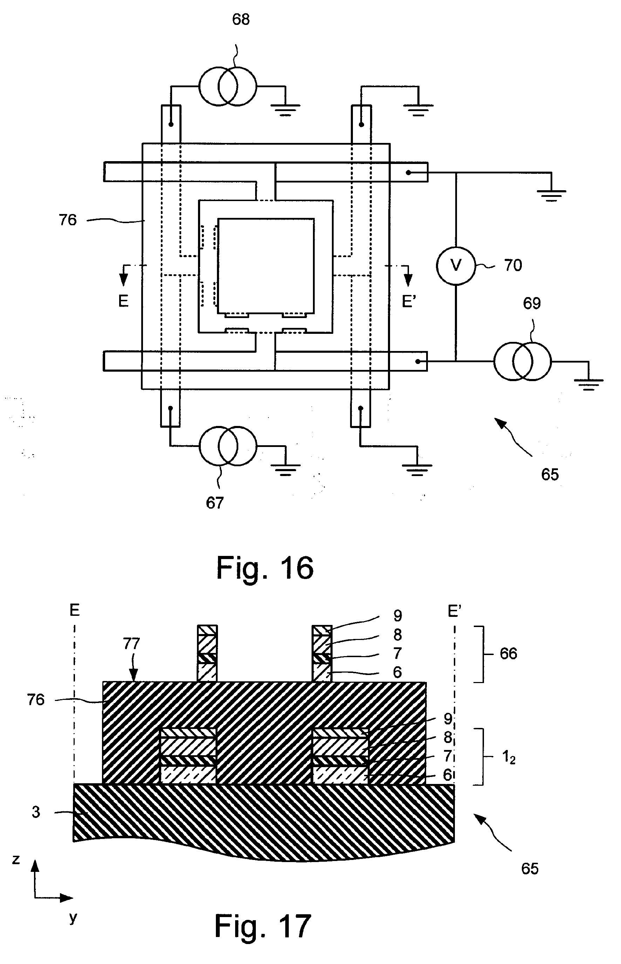

Referring in particular to Figures 16 and 17, the SQUID $1_2$ and exit SQUID 66 are stacked, separated by an insulating layer 76. In this example, the SQUID $1_2$ and exit SQUID 66 are substantially the same. The insulating layer 76 comprises silicon dioxide and has a thickness of about 1 $\mu$m. Other insulating layers such as polyimide may be used. Preferably, the insulating layer 73 provides a substantially flat upper surface 77 on which to fabricate the exit SQUID 66.

The SQUID $1_2$ may be arranged above or below the exit SQUID 66 in a stacked structure. This helps to improve flux coupling between the SQUID $1_2$ and the exit SQUID 66. However, the SQUID $1_2$ and exit SQUID may be arranged side-by-side.

The antenna 74 is placed close (e.g. about 2 mm) from the surface of the chip (not shown) over the device 65 so that the microwave pulses are directed perpendicularly to the plane of the SQUID $1_2$.

*Operation*

A process by which a qubit is prepared and manipulated will now be described:

Firstly, an initial state, for example $|\psi_i\rangle = 2^{-\frac{1}{2}} (|0\rangle + |1\rangle)$ (i.e. $|0'\rangle$), is prepared. This comprises applying a heater current $I_{beater}$ = 150 $\mu$A using current source 68 so as to switch the Nb layer 6 into a normal state. The heater current $I_{beater}$ is then removed.

Secondly, a set of transformations of the initial state is performed.

The transformations include a first transformation comprising applying a first microwave pulse $72_1$ having a frequency $\nu$ for a predetermined time $t_1$. For example, $\nu$ = 25 GHz and $t_1$, $\approx$ 15 ns. The pulse 72, is arranged to cause a so-called Hadamard Transformation, $U_H$, in which $2^{-\frac{1}{2}} (|0\rangle + (1\rangle)$ is transformed into $|1\rangle$. The Hadamard Transform $U_H$ is a unitary transformation commonly used quantum algorithms, such that:

$$U_H|0\rangle = 2^{-\frac{1}{2}}(|0\rangle + |1\rangle)$$

$$U_H|1\rangle = 2^{-\frac{1}{2}}(|0\rangle - |1\rangle)$$

For example, Hadamard Transform $U_H$ can be used to define new basis states:

$$|0'\rangle = 2^{-\frac{1}{2}}(|0\rangle + |1\rangle)$$

$$|1'\rangle = 2^{-\frac{1}{2}}(|0\rangle - |1\rangle)$$

This represents a 45° rotation of the initial state in Hilbert space. The value of $t_1$ may be found by routine experiment in a similar way to that described in EP-A-1262911.

The transformations include a second transformation comprising waiting 10 ns so as to allow the system to evolve.

The transformations include a third transformation comprising applying another microwave pulse $72_2$ having a frequency $\nu$ for a predetermined time $t_2$. For example, a $\nu$ = 25 GHz and $t_2 \approx 15$ ns. The other pulse $74_2$ also results in a Hadamard Transformation, $U_H$.

The transformations may be repeated.

The set of transformations transforms the initial state $|0\rangle$ into a final state $|\psi_f\rangle$, which may consist of mixture of states $|0\rangle$ and $|1\rangle$.

Finally, a measurement of the final state $|\psi_f\rangle$ is carried out. This comprises applying a current $I_r$ = 2 mA using current source 69 and measuring the flux using the exit SQUID 66 in terms of an output voltage V.

**Flux double-qubit device 78**

*Device layout*

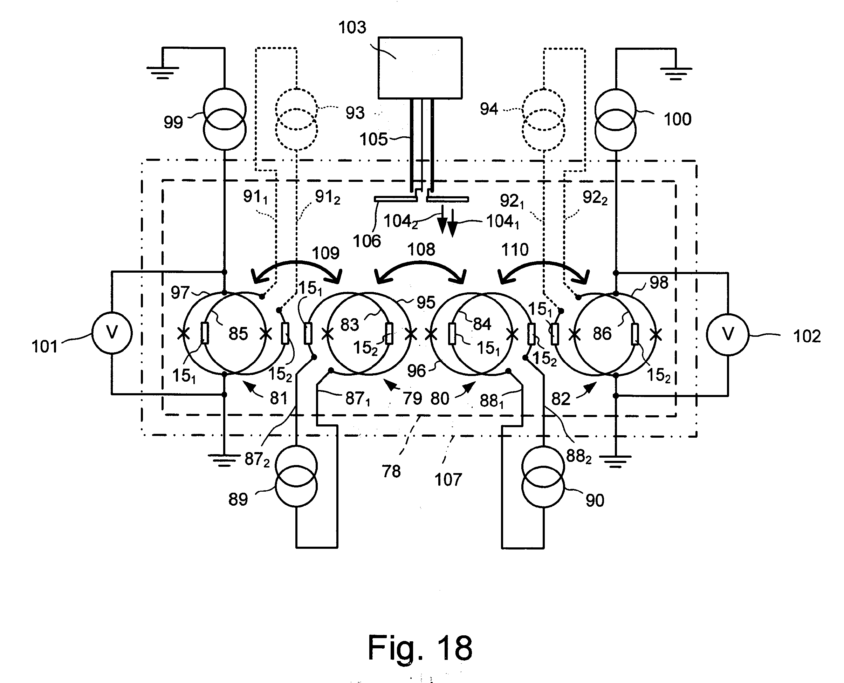

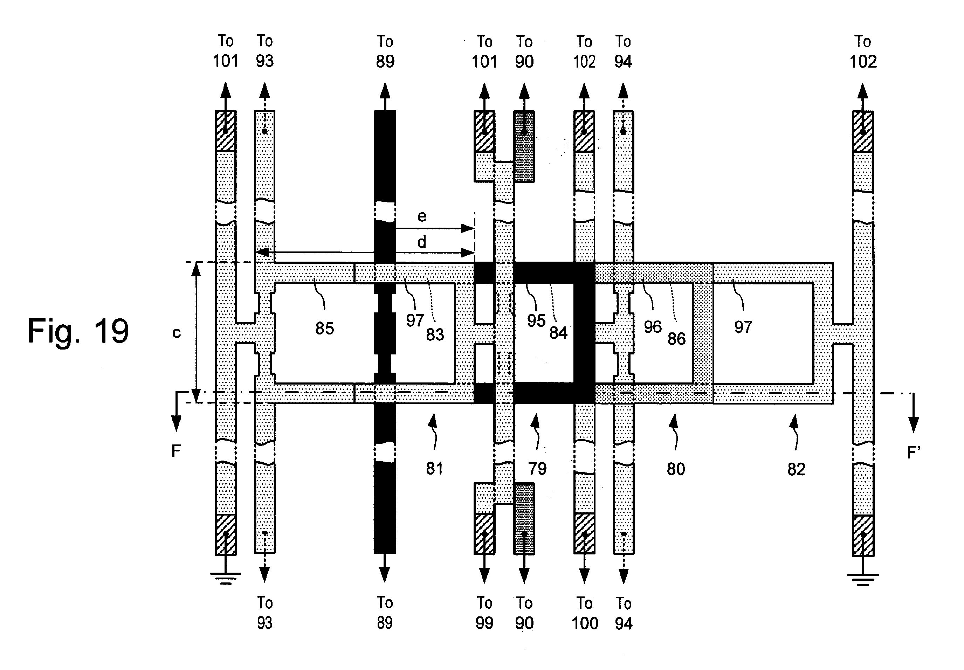

Referring to Figures 18, 19 and 20, a system is shown which includes a second embodiment of a device 78 for quantum computing in accordance with the present invention is shown. Figure 19 represents a simplified view of the device 78 in which layers of insulating material separating normal and insulating layers are omitted to help aid clarity.

The device 78 includes first and second SQUIDs 79, 80 for providing first and second qubits respectively, i.e. the device 78 is a double-qubit device. The device 78 also includes first and second SQUIDs ("exit SQUIDs") 81, 82 for measuring the state of the first and second SQUIDs 79, 80 respectively.

The first and second SQUIDs 79, 80 and the first and second exit SQUIDs 81, 82 are similar to the SQUID 1 (Figure 1) described earlier, but differ from it in several respects.

Firstly, heater layers 83, 84, 85, 86 of the SQUIDs 79, 80 and the exit SQUIDs 81, 82 do not form (closed) loops. Pairs of leads $87_1$, $87_2$, $88_1$, $88_2$ are provided for each SQUID 79, 80 and arranged so as to allow current sources 89, 90 to drive heater currents $I_{heater}$ through the heaters $15_1$, $15_2$ in the SQUID 79, 80 in series. Likewise, optional additional leads $91_1$, $91_2$, $92_1$, $92_2$ may be provided for the exit SQUIDs 81, 82 and arranged so as to allow optional current sources 93, 94 to drive heater currents $I_{beater}$ through the heaters $15_1$, $15_2$ in the exit SQUIDs 81, 82 in series.

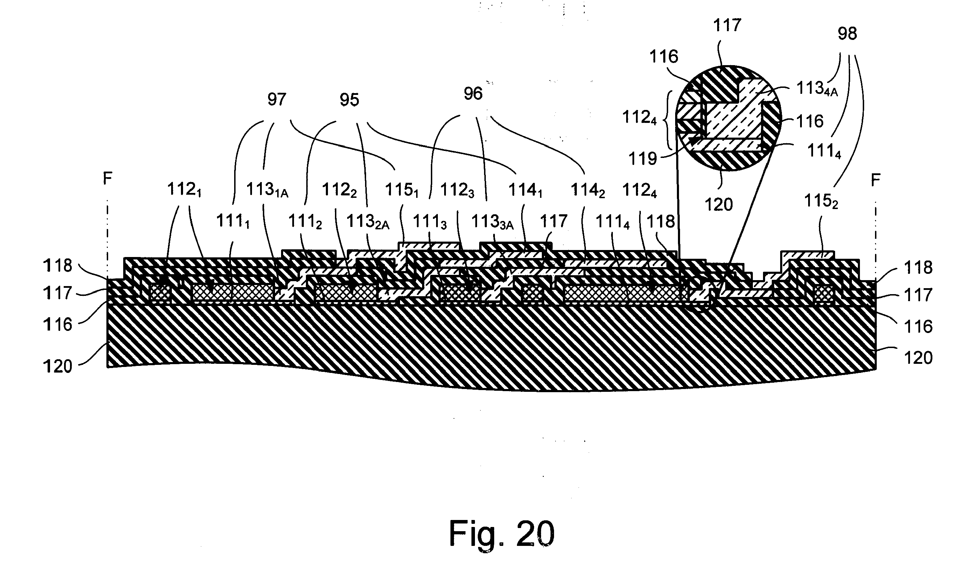

Secondly, superconducting material loops 95, 96, 97, 98 are formed using a plurality of overlapping, connected segments $111_1,...,115_4$ (Figure 20) of superconducting material, e.g. Nb. As will be described in more detail later, using segments $111_1,...,115_4$ (Figure 20) and insulating layers 116,..., 119 (Figure 20) between segments $111_1,...,115_4$ of different SQUIDs 79, 80 and exit SQUIDs 81, 82 allows each SQUID 79, 80 and exit SQUID 81, 82 to overlap neighbouring SQUIDs 79, 80 and exit SQUIDs 81, 82.

Thirdly, no current sources are provided or arranged to drive a current through the superconducting material loops 94, 96 of SQUIDs 79, 80.

Current sources 99, 100 are provided for applying a current bias I through the superconducting material loops 95, 96, of the exit SQUIDs 81, 82 and voltage meters 101, 102 are provided for measuring the voltage drop V.

A signal generator 103 is used to provide microwave pulses $104_1$, $104_2$ for qubit manipulation. The signal generator 103 can output signals of the order of 1 and/or 10 GHz. Typically, the signal generator 103 can output signals with power in a range between -40 to 20 dBm. The signal generator 103 is connected via a semi-rigid co-axial cable 105 to a Hertzian dipole antenna 106. Other signal generators or sources, waveguides and emitters may be used. For example, a Gunn diode may be used. A Horn antenna may be used as an emitter. The antenna 106 is placed close (e.g. about 2 mm or less) from the surface of the chip (not shown) over the device 78 and arranged so that the microwave pulses are directed towards the device 78. It will be appreciated that the proximity of the antenna 106 to the device 78 needed for control depends, *inter alia,* upon the power output of the signal generator 103.

The device 78 is placed in a system 107 for cooling the device to a temperature at or below 4.2 K. In this example, the system 107 is a dilution refrigerator. However, other cooling systems may be used, such as a continuous flow cryostat.

The double-qubit device 78 is based on flux qubits. Basis states can be defined for each qubit, namely:

$$|0\rangle \equiv |\text{clockwise}\rangle$$

$$|1\rangle \equiv |\text{anti-clockwise}\rangle$$

where clockwise and anti-clockwise refer to directions of current flow through in the superconducting loops 95, 96 (as viewed from above). As explained earlier, the basis states can be defined in terms of flux direction, for example $|\text{up}\rangle$ and $|\text{down}\rangle$.

Also, as explained earlier, more complex basis states can be defined, in particular:

$$|0'\rangle = 2^{-1/2}(|0\rangle + |1\rangle)$$

$$|1'\rangle = 2^{-1/2}(|0\rangle - |1\rangle)$$

The SQUIDs 79, 80 and exit SQUIDs 81, 82 are coupled to adjacent neighbouring SQUIDs 79, 80 and/or exit SQUIDs 81, 82. Thus, a first flux coupling 108 inductively couples the first and second SQUIDs 79, 80. A second flux coupling 109 inductively couples the first SQUID 79 with the first exit SQUID 81 and a third flux coupling 110 inductively couples the second SQUID 80 with the first exit SQUID 81.

Referring in particular to Figure 20, the loops 95, 96, 97, 98 of superconducting material are formed from a base superconducting material layer $111_1$, $111_2$, $111_3$, $111_4$ within an etched multilayer structure $112_1$, $112_2$, $112_3$, $112_4$, a first intermediate superconducting material segment $113_{1A}$, $113_{2A}$, $113_{3A}$, $113_{4A}$, a second intermediate superconducting material segment $113_{1B}$, $113_{2B}$, $113_{3B}$, $113_{4B}$ (not shown) and an upper superconducting material layer $114_1$, $114_2$, $115_1$, $115_2$. As will be explained in more detail later, two levels of upper superconducting material layer $114_1$, $114_2$, $115_1$, $115_2$ are used. In this example, the same superconducting material, e.g. Nb, is used. However, different materials can be used in different layers $111_1$,...,$115_2$.

The superconducting material layers $111_1$,...,$115_2$ of different SQUIDs 79, 80 and exits SQUIDs 81, 82 are isolated from each other by a base insulating material layer 116, intermediate insulating material layer 117 and an upper insulating material layers 118. In this example, the same insulating material, e.g. $SiO_2$, is used. However, other materials, e.g. $Si_xN_y$, may be used.

The superconducting material layers $113_1$, $113_2$, $113_3$, $113_4$ are laterally separated from other parts of the etched multilayer structure $112_1$, $112_2$, $112_3$, 112 by a gap 119 of a few 10's or 100's of nm, which may be filled with intermediate insulating or left as a void.

The layers $111_1$,...,$115_2$, 116..., 118 are formed on an insulating material, e.g. $SiO_2$, layer 120 formed on a silicon substrate (not shown)

The etched multilayer structure $112_1$, $112_2$, $112_3$, $112_4$ comprises the same materials and have the same thicknesses as the layers 6, 7, 8, 9 (Figure 1) described earlier. Thus, the base superconducting layer $111_1$, $111_2$, $111_3$, $111_4$ corresponds to the first layer 6 (Figure 1).

Referring in particular to Figure 19, the superconducting material loops 95, 96, 97, 98 are generally rectangular having sides of lengths 1.4 $\mu$m and 2.2 $\mu$m as indicated by arrows c and d respectively. Adjacent loops 95, 96, 97, 98 overlap by 0.5 $\mu$m as indicated by arrow e. It will be appreciated that the size of loops 95, 96, 97, 98 and overlap can be varied. If the size of the overlap is reduced, then it may be possible to reduce the number of segments needed to form the superconducting loops. Conversely, if the size of the overlap is increased, then it may be necessary to increase the number of segments needed to form the superconducting loops.

The device 78 may be modified to include more than two SQUIDs so as to provide a device having more than two qubits. The SQUIDs need not be arranged in a linear chain.

*Operation*

Referring again to Figure 18, the two qubits are prepared, manipulated and measured in a similar way to that described earlier.

Firstly, an initial state, for example $|\psi_i\rangle = |0'\rangle|0'\rangle$, is prepared in same way to that described earlier, i.e. by applying a heater currents using current sources 89, 90 so as to switch the superconducting loops 95, 96 into a normal state

Secondly, a set of transformations of the initial state is performed in the same way as that described earlier.

Finally, a measurement of the final state $|\psi_f\rangle$ is carried out, in the same way to that described earlier, but using two exit SQUIDs 81, 82.

Those skilled in the art will appreciated that the states can prepared, manipulated and measured in different ways and that the values of heater current, bias current and microwave pulse duration and frequency can be found using routine experiment.

*Fabrication*

Referring to Figures 21a to 21g, a process of fabricating the device 78 is will now be described.

A layer of Nb having a thickness of 50 nm is sputtered in an UHV system onto an oxidized silicon substrate 120. The niobium layer is patterned using an Al etch mask defined using electron beam lithography and $CF_4/O_2/SiCl_4$ RIE as described earlier so as to define a Nb mesa.

Layers of $SiO_2$ and Ti having a thicknesses of 30 nm and 50 nm are sputtered over the exposed surface of the patterned Nb film and substrate, as described earlier, so as to form a Nb/ $SiO_2$ /Ti multilayer.

Referring to Figure 21a, the Nb/$SiO_2$ /Ti multilayer is patterned using a Cr layer defined using electron beam lithography and $CF_4/O_2$ RIE to form first, second, third and fourth multilayer structures $112_1'$, $112_2'$, $112_3'$, $112_4'$. Each multilayer structure $112_1'$, $112_2'$, $112_3'$, $112_4'$ has, as its bottom layer (closest to the substrate 120), a base superconducting material layer $111_1$, $111_2$, $111_3$, $111_4$ (Figure 20).

The multilayer structures $112_1$, $112_2$, $112_3$, $112_4$ include 'C'-shaped portions $121_1$, $121_2$, $121_3$, $121_4$ which define first segments of the loops 95, 96, 97, 98 (Figure 19) of superconducting material.

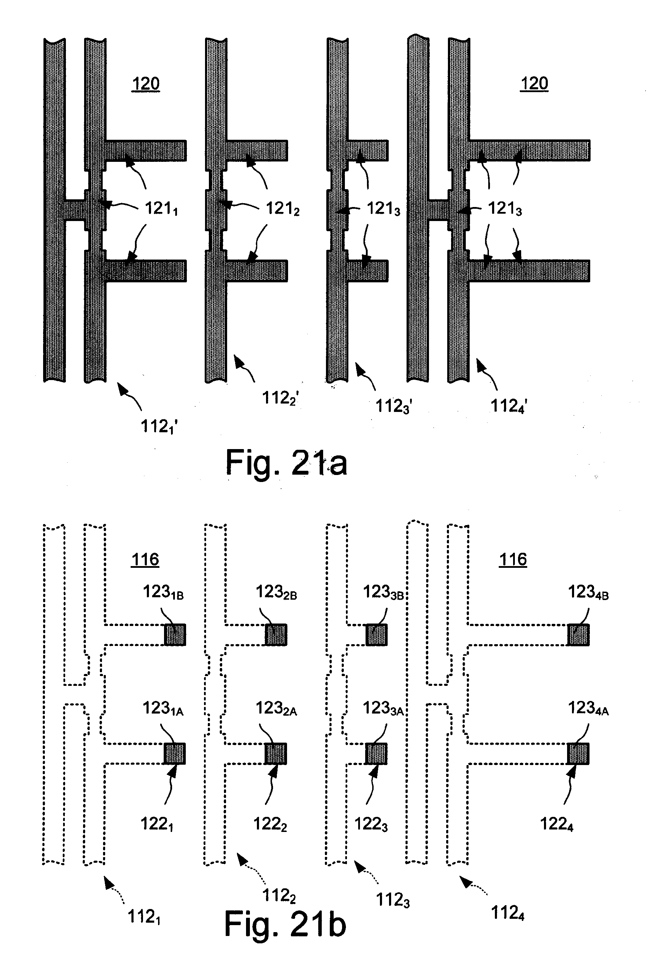

A layer of $SiO_2$ having a thickness of 60 nm is sputtered over the exposed surface of the chip. The $SiO_2$ layer is patterned using electron beam lithography and $CF_4/O_2$ RIE so as to open four pairs of windows $122_{1A}$, $122_{1B}$, $122_{2A}$, $122_{2B}$, $122_{3A}$, $122_{3B}$, $122_{4A}$, $122_{4B}$ (Figure 21b) over distal ends of the 'C'-shaped portions $121_1$, $121_2$, $121_3$, $121_4$.

Referring to Figure 21b, the exposed distal regions of the multilayer structures $112_1'$, $112_2'$, $112_3'$,$112_4'$ are etched back until the niobium base layer $111_1$, 111, $111_3$, $111_4$ (Figure 20) is reached and thereby provide exposed Nb regions $123_{1A}$, $123_{1B}$, $123_{2A}$, $123_{2B}$, $123_{3A}$, $123_{3B}$, $123_{4A}$, $123_{4B}$. A (thinned) $SiO_2$ layer 116 is left over the rest of the etched multilayer structures $112_1$, $112_2$, $112_3$,$112_4$.

A layer of niobium having a thickness of 50 nm is sputtered over the exposed Nb regions $123_{1A}$, $123_{1B}$, $123_{2A}$, $123_{2B}$, $123_{3A}$, $123_{3B}$, $123_{4A}$, $123_{4B}$ and the thinned $SiO_2$ layer 116.

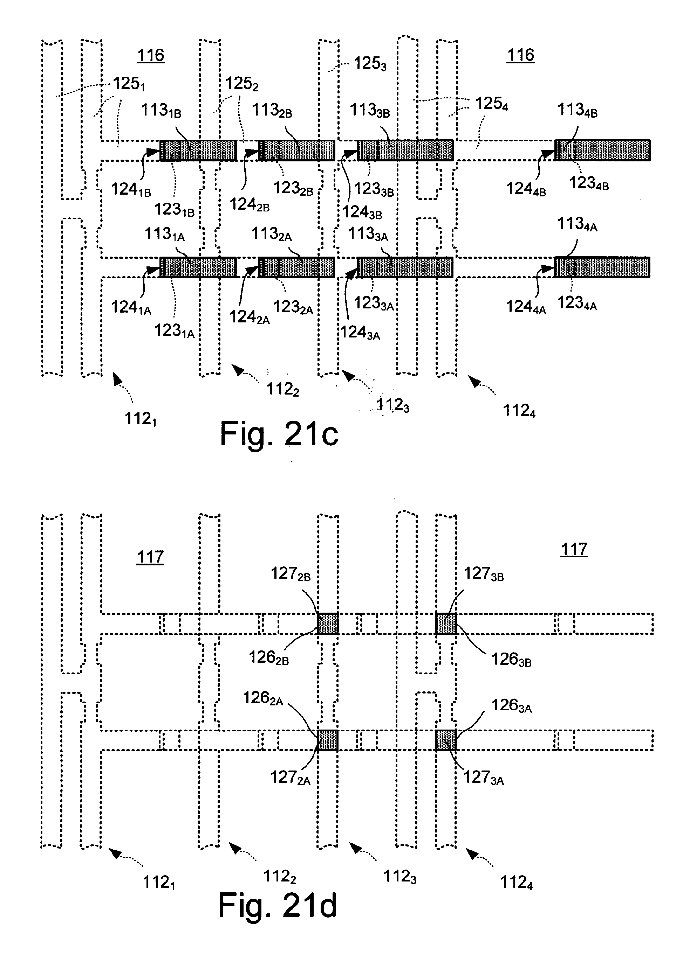

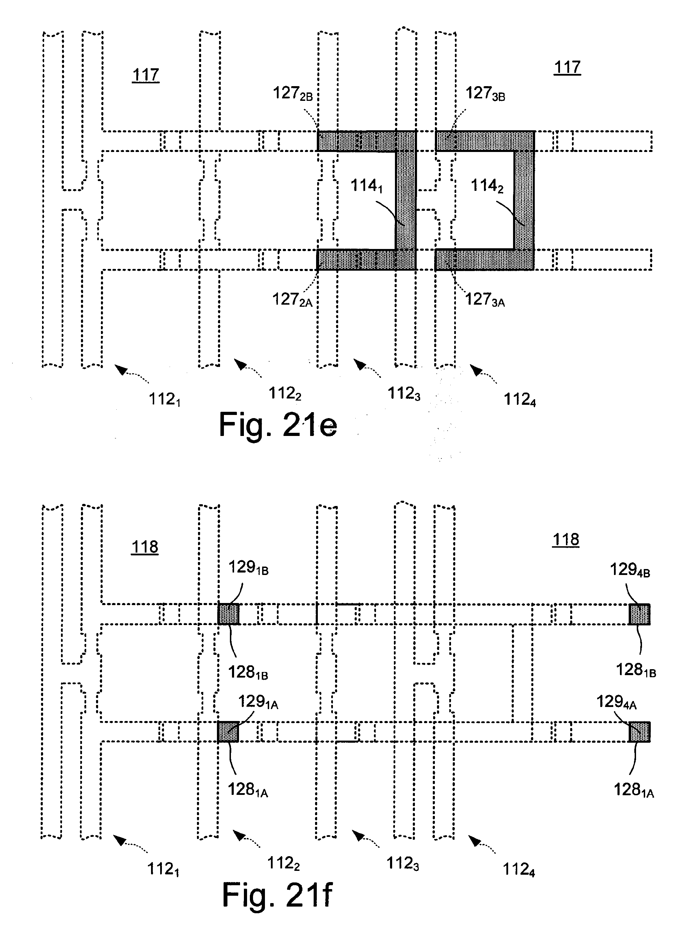

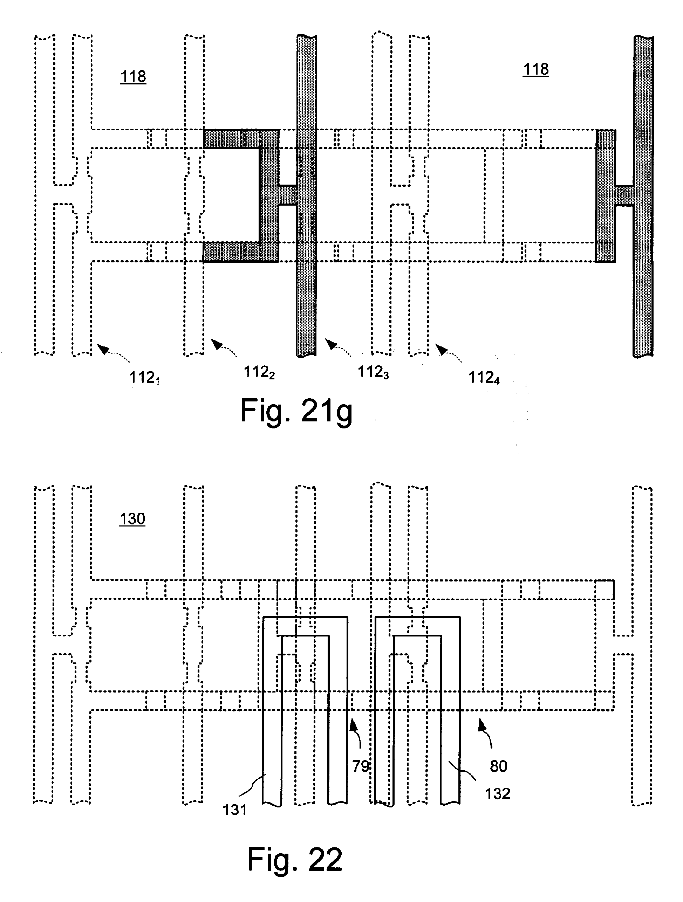

Referring to: Figure 21 c, the Nb layer is patterned using an Al etch mask defined using electron beam lithography and $CF_4/O_2/SiCl_4$ RIE as described earlier so as to produce first, second, third and fourth pairs of intermediate segments $113_{1A}$, $113_{1B}$, $113_{2A}$, $113_{2B}$; $113_{3A}$, $113_{3B}$, $113_{4A}$, $113_{4B}$ which overlap respective exposed Nb regions $123_{1A}$, $123_{1B}$, $123_{2A}$, $123_{2B}$, $123_{3A}$, $123_{3B}$, $123_{4A}$, $123_{4B}$ and thereby provide extensions to the base superconducting material layers $111_1$, $111_2$, $111_3$, $111_3$ (Figure 20).

The intermediate segments $113_{1A}$, $113_{1B}$, $113_{2A}$, $113_{2B}$, $113_{3A}$, $113_{3B}$, $113_{4A}$, $113_{4B}$ do not overlap edges $124_{1A}$, $124_{1B}$, $124_{2A}$, $124_{2B}$, $124_{3A}$, $124_{3B}$, $124_{4A}$, $124_{4B}$ between the exposed Nb regions $123_{1A}$, $123_{1B}$, $123_{2A}$, $123_{2B}$, $123_{3A}$, $123_{3B}$, $123_{4A}$, $123_{4B}$ and the rest $125_1$, $125_2$, $125_3$, $125_4$ of the multilayer structures $112_1$, $112_2$, $112_3$, $112_4$.

A layer of $SiO_2$ having a thickness of 30 nm is sputtered over the exposed surface of the chip.

Referring to Figure 21 d, the $SiO_2$ layer is patterned using electron beam lithography and $CF_4/O_2$RIE so as to open two pairs of windows $126_{2A}$, $126_{2B}$, $126_{3A}$, $126_{3B}$ over distal ends of the second and third pairs of intermediate segments $113_{2A}$, $113_{2B}$, $113_{3A}$, $113_{3B}$ (furthest way from the base superconducting material layers $111_2$, $111_3$) to reveal exposed Nb regions $127_{2A}$, $127_{2B}$, $127_{3A}$, $127_{3B}$ of the intermediate segments $113_{2A}$, $113_{2B}$, $113_{3A}$, $113_{3B}$ (Figure 21c).

A layer of niobium having a thickness of 50 nm is sputtered over the exposed Nb regions $127_{2A}$, $127_{2B}$, $127_{3A}$, $127_{3B}$ and the $SiO_2$ layer 117.

Referring to Figure 21e, the Nb layer is patterned using an Al etch mask defined using electron beam lithography and $CF_4/O_2/SiCl_4$ RIE to produce two back-to-front 'C'-shaped segments $128_2$, 128 which overlap respective exposed Nb regions $127_{2A}$, $127_{2B}$, $127_{3A}$, $127_{3B}$ thereby closing the first and second third loops 95, 96 (Figure 19) of superconducting material.

A layer of $SiO_2$ having a thickness of 30 nm is sputtered over the exposed surface of the chip.

Referring to Figure 21f, the $SiO_2$ layer is patterned using electron beam lithography and $CF_4/O_2$ RIE so as to open two pairs of windows $128_{2A}$, $128_{2B}$, $128_{3A}$, $128_{3B}$ over distal ends of the first and fourth pairs of intermediate segments $113_{1A}$, $113_{1B}$, $113_{4A}$, $113_{4B}$ (furthest way from the base superconducting material layers $111_1$, $111_4$) to reveal exposed niobium regions $129_{1A}$, $129_{1B}$, $129_{4A}$, $129_{4B}$ of the intermediate segments $113_{1A}$, $113_{1B}$, $113_{4A}$, $113_{4B}$ (Figure 21c).

A layer of Nb having a thickness of 50 nm is sputtered over the exposed Nb regions $119_{2A}$, $119_{2B}$, $119_{3A}$, $119_{3B}$ and the $SiO_2$ layer 109.

Referring to Figure 21g, the Nb layer is patterned using an Al etch mask defined using electron beam lithography and $CF_4/O_2/SiCl_4$ RIE to produce two reverse 'C'-shaped segments $115_1$, $115_2$ which overlap respective exposed Nb regions $129_{1A}$, $129_{1B}$, $129_{4A}$, $129_{4B}$ thereby closing the third and fourth loops 97, 98 (Figure 19) of superconducting material.

Additional lithography, RIE and metallizations are used to form bond pads (not shown) to base superconducting material layers $111_1$, $111_4$ and heater layers 83, 84, 85, 86.

Referring to Figure 22, an additional insulating layer 130, e.g. 50 nm-thick layer of $SiO_2$, may be deposited over the surface of the chip and first and second looped conducting tracks 131, 132, e.g. 100 nm-thick layer of gold (Au) having a track width of 200 nm, may be provided over the first and second SQUIDs 79, 80 so as to control the first and second SQUIDs 79, 80 independently. In this case, the looped conducting tracks 131, 132 comprise only single turns. However, multiple turns may be used.

**Charge double-qubit device 133**

*Device layout*

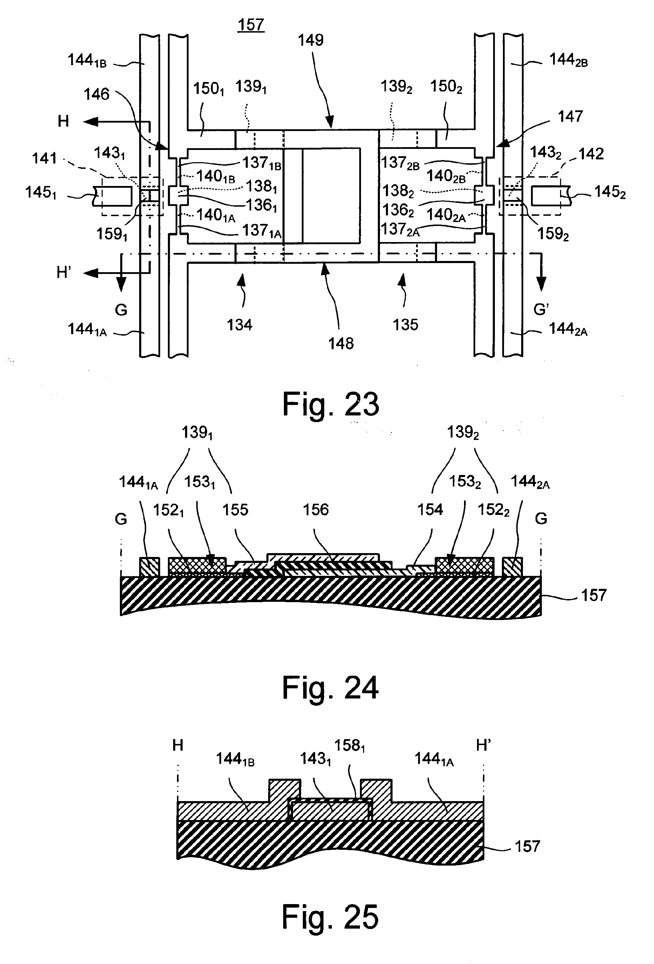

Referring to Figures 23 and 24, a system is shown which includes a third embodiment of a device 133 for quantum computing in accordance with the present invention is shown.

The device 133 is similar to the device 78 (Figure 19) described earlier, but differs in two main respects.

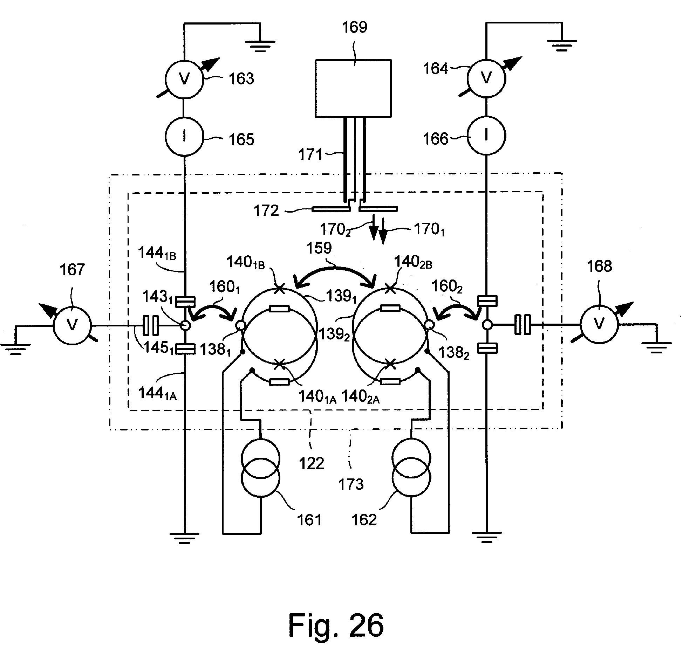

Firstly, the first and second SQUIDs 134, 135 each have a ring portion in which a central section 136 disposed between constrictions $137_1$, $137_2$ is smaller, in this example 100 nm long and 100 nm wide. The constrictions $137_1$, $137_2$ are also narrower, for example 50 nm. Thus, an island $138_1$,$138_2$ (Figure 26) is formed in a superconducting loop $139_1$, $139_2$ between first and second Josephson junctions $140_{1A}$, $140_{1B}$, $140_{2A}$, $140_{2B}$ which has a charging energy $E_c$ greater than superconducting gap $\Delta$. Thus, basis states for the first and second SQUIDs 134, 135 are defined as:

$$|0\rangle \equiv |\text{excess charge on island } 138_1, 138_2\rangle$$

$$|1\rangle \equiv |\text{excess charge not on island } 138_1, 138_2\rangle$$

Secondly, the states of the first and second SQUIDs 134, 135 are measured using first and second single electron transistors (SETs) 141, 142. Each transistor 141, 142 comprises an island $143_1$, $143_2$ disposed between a pair of leads $144_{1A}$, $144_{1B}$, $144_{2A}$, $144_{2B}$, and electrostatically coupled by a gate electrode $145_1$, $145_2$. In some embodiments, only one SET is provided. In this example, the islands $143_1$, $143_2$, leads $144_{1A}$, $144_{1B}$, $144_{2A}$, $144_{2B}$, and a lateral gate electrode $145_1$, $145_2$ are formed of aluminium (Al) having a thickness of 50 nm.

In this example, the charge qubit device 133 also differs in other respects from the example of the flux qubit device 78 described earlier.

The SQUIDs 134, 135 are arranged such that the islands $143_1$, $143_2$ of the SETs 141, 142 can be placed close to, preferably less than 50 nm and more preferably less than 10 nm, the islands $138_1$, $138_2$ of the SQUIDs 134, 135. Thus, as shown in Figure 23, the SQUIDs 134, 135 overlap, but are arranged as mirror images or "back-to-back" so that their islands "face out" from ends 146, 147 of the chain. Alternatively, the SQUIDs 134, 135 may be rotated through 90° such that the islands face out from sides 148, 149 of the chain.

If three or more SQUIDs are provided in a chain having one or more SQUID arranged between outermost SQUIDS, then only the outermost SQUIDs need be orientated such that their islands are "face out" from the end of the chain.

Only SQUIDs which need to be measured (which may be at the ends of the chain or between the ends of the chain), which are measured by SETs and which are arranged in plane with the SQUID(s) need "face out". If the SETs are placed under or over SQUIDs, then the islands need not "face out".

The SQUIDs 134, 135 also include heater layers $150_1$, $150_2$ for controlling the superconducting material loops $139_1$, $139_2$ in the manner described earlier.

Referring in particular to Figure 24, loops $139_1$, $139_2$ of superconducting material are formed from a lower superconducting material layer $152_1$, $152_2$ within an etched multilayer structure $153_1$, $153_2$ and upper superconducting material layer 154, 155. The upper superconducting material layers 154, 155 are isolated from each other by an insulating material layer 156. The lower superconducting material layers $152_1$, $152_2$ are separated from other parts of the etched multilayer structure $153_1$, $153_2$ by a gap (not shown) of a few 10's or 100's of nm, which may be filled with intermediate insulating or left as a void. The layers $152_1$, $152_2$, 153, 154, 155, 156 are formed on a $SiO_2$ layer 157 formed on a silicon substrate (not shown)

The etched multilayer structure $153_1$, $153_2$ comprises the same materials and have the same thicknesses as the layers 6, 7, 8, 9 (Figure 1) described earlier. Thus, the lower superconducting material layer $152_1$, $152_2$ corresponds to the first layer 6 (Figure 1).

The superconducting loops $139_1$, $139_2$ are generally rectangular having sides of lengths 1.4 $\mu$m and 2.2 $\mu$m. The loops 150, 151 overlap by 0.5 $\mu$m. It will be appreciated that the size of loops $139_1$, $139_2$ and overlap can be varied.

If the number of SQUIDs is increased and/or is the size of overlap is increased, then it may be necessary to increase the number of segments needed to form the superconducting loops.

The device 133 may be modified to include more than two SQUIDs so as to provide a device having more than two qubits. The SQUIDs need not be arranged in a linear chain.

Referring in particular to Figure 25, the islands $143_1$, $143_2$ are separated from the leads $144_{1A}$, $144_{1B}$, $144_{2A}$, $144_{2B}$ by a tunnel barrier $158_1$, $158_2$, in this example formed of aluminium oxide ($Al_2O_3$). In this example, the islands $143_1$, $143_2$ are 50 nm long, 50 nm wide and about 50 nm thick.

Referring to Figure 26, a flux coupling 159 inductively couples the SQUIDs 134, 135. First and second electrostatic couplings $160_1$, $160_2$ couple the first SQUID 134 to the first SET 141 and the second SQUID 135 to the second SET 142 respectively.

Current sources 161, 162 are provided for applying a heater current $I_{beater}$ through the niobium loops $139_1$, $139_2$.

Voltage sources 163, 164 are provided for applying biases to between the leads of the single electron transistors and current meters 165, 166 are arranged to measure current $I_{SD}$ through the channel. Voltage sources 167, 168 are provided for applying a gate bias $V_g$.

A signal generator 169 is used for providing microwave pulses $170_1$, $170_2$ for qubit manipulation. The signal generator 169 is connected via a semi-rigid co-axial cable 171 to a Hertzian dipole antenna 172. Other microwave sources, waveguides and emitters may be used. For example, a Gunn diode may be used as a source. A Horn antenna may be used as an emitter. The antenna 172 is placed close (e.g. about 2 mm or less) from the surface of the chip (not shown) over the device 133 and arranged so that the microwave pulses are directed towards the device 133.

The device 133 is placed in a system 173 for cooling the device to a temperature at or below 4.2 K. In this example, the system 173 is a dilution refrigerator. However, other cooling systems may be used, such as continuous flow cryostats.

*Operation*

The two qubits are prepared, manipulated and measured in a similar way to that described earlier.

Firstly, an initial state, for example $|\psi_i\rangle = |0'\rangle|0'\rangle$, is prepared in same way to that described earlier, i.e. by applying a heater currents using current sources 161, 162 so as to switch the superconducting loops $139_1$, $139_2$ into a normal state

Secondly, a set of transformations of the initial state is performed in the same way as that described earlier.

Finally, a measurement of the final state $|\psi_f\rangle$ is carried out by measuring charge using the single electron transistors 141, 142 in a manner well known *per se.*

Those skilled in the art will appreciated that the states can prepared, manipulated and measured in different ways and that the values of heater current, bias current, microwave pulse duration and frequency can be varied using routine experiment.

*Fabrication*

The device 133 is fabricated in a similar way to the device 78 (Figures 18 & 19) described earlier and so the process of fabricating the device 133 will only briefly be described here.

The etched multilayer structure $153_1$, $153_2$ are fabricated in a similar way to the second and third etched multilayer structure $112_2$, $112_3$ (Figure 19), as described earlier, although a different scanning electron-beam pattern is used.

A layer of niobium is deposited and patterned to define upper superconducting material layer 154. A layer of silicon dioxide is deposited and patterned, then a layer of niobium is deposited and patterned to define upper superconducting material layer 155.

Electron beam lithography is employed to pattern a layer of thermally-evaporated aluminium using the so-called "lift-off" process so as to define islands $143_1$, $143_2$. A surface oxide forms naturally over the islands $143_1$, $143_2$. Electron beam lithography is then used to pattern a layer of aluminium using the lift-off process so as to define leads $114_{1A}$, $114_{1B}$, $114_{2A}$, $114_{2B}$ and gate electrode $145_1$, $145_2$. The leads $114_{1A}$, $114_{1B}$, $114_{2A}$, $114_2$ overlap the oxidized islands $143_1$, $143_2$ and tunnel barriers $158_1$, $158_2$ form between the islands $143_1$, $143_2$ and the leads $114_{1A}$, $114_{1B}$, $114_{2A}$, $114_2$.

The SETs 141, 142 (Figure 23) may be formed first.

It will be appreciated that many modifications may be made to the embodiments hereinbefore described. For example SQUID need not be upstanding from a top surface of the substrate, but, for example, may be suspended above it. The devices for quantum computing need not be based on flux or charge qubits, but can be based on a phase qubit, wherein the charging energy of the island and the superconducting gap are comparable. Single-electron (or hole) transistors may have different configurations and/or be formed from other materials. For example, highly doped n- or p-type silicon (Si), silicon-germanium or δ-doped gallium arsenide nanowires having gates may be used. Thus, smaller islands having larger charging energies may be used.

**Claims**

1. Apparatus comprising:

   a superconducting quantum interference device (SQUID) ($1_1$; $1_2$; 79; 134) having first and second Josephson junctions and first and second phonon generators configured to control charge carrier transport through said first and second Josephson junctions respectively; and
   a device ($48_1$, $48_2$, $48_n$; 66; 81; 141), inductively or electrostatically coupled to the SQUID, for measuring a state ($|0'\rangle$, $|1'\rangle$) of the SQUID.

2. Apparatus according to claim 1, which is for quantum computing.

3. Apparatus according to claim 1 or 2, wherein the SQUID ($1_2$; 79; 134) and the measuring device (66; 81; 141) are disposed on a substrate (3; 120; 157).

4. Apparatus according to any one of claims 1 to 3, wherein the measuring device is a SQUID (66; 81).

5. Apparatus according to any one of claims 1 to 3, wherein the measuring device (141) is a single charge transistor.

6. Apparatus according to claim 5, wherein the SQUID ($1_2$; 79; 134) comprises:

   an island of superconducting material disposed between the first and second Josephson junctions, the island and the junctions arranged such that the charging energy of the island is larger than the superconducting gap of the superconducting material.

7. Apparatus according to claim 5 or 6, wherein the SQUID ($1_2$; 79; 134) comprises:

   an island disposed between the first and second Josephson junctions, the island having dimensions smaller than 50 nm.

8. Apparatus according to any preceding claim, further comprising:

   a gate (71, 73, 74; 103, 105, 106; 131; 169; 171, 172) for controlling the state of the SQUID ($1_2$; 79; 134).

9. Apparatus according to claim 8, wherein the gate comprises a microwave source (71, 73, 74; 103, 105, 106; 169; 171, 172).

10. Apparatus according to claim 9, wherein the microwave source includes a microwave emitter (74; 105; 172) arranged sufficiently close to irradiate the SQUID with microwaves.

11. Apparatus according to any preceding claim, comprising:

    at least one additional SQUID (80; 134) coupled to the SQUID (79; 134).

12. Apparatus according to any preceding claim, comprising:

    at least two additional SQUIDs, one of the additional SQUIDs coupled to the SQUID.

13. Apparatus according to claim 11 or 12, comprising:

    a further device (82; 142), coupled to the additional SQUID (80; 134) or one of the additional SQUIDs, for measuring a state ($|0'\rangle$, $|1'\rangle$) of said the or said one of the additional SQUIDs.

14. Apparatus according to any one of claims 11 to 13, wherein the SQUID (79; 134) and the additional SQUID (80; 134) or one of the additional SQUIDs overlap.

**15.** A method of operating apparatus comprising a superconducting quantum interference device (SQUID) ($1_2$; 79; 134) having first and second Josephson junctions and first and second phonon generators configured to control charge carrier transport through said first and second Josephson junctions respectively; and a device (66; 81; 141), coupled to the SQUID, for measuring a state ($|0'\rangle$, $|1'\rangle$) of the SQUID, the method comprising:

causing generation of phonons so as to set the SQUID in an initial state; and
thereafter, measuring a final state of the SQUID ($1_2$; 79; 134).

**16.** A method according to claim 15, wherein the first and second phonon generators comprise constrictions in a normal conducting channel and causing generation of phonons comprises causing current to flow through said channel.

**17.** A method according to claim 15 or 16, wherein the apparatus further comprises a gate for controlling the state of the SQUID and the method further comprises:

manipulating the initial state of the SQUID ($1_2$; 79; 134).

**18.** A method according to claim 16, wherein the gate comprises a microwave source and manipulating the initial state of the SQUID comprises applying a microwave pulse to the SQUID ($1_2$; 79; 134).

**19.** A method of operating apparatus comprising a superconducting quantum interference device (SQUID) ($1_1$) having first and second Josephson junctions and first and second phonon generators configured to control charge carrier transport through said first and second Josephson junctions respectively; and a device (42), inductively or electrostatically coupled to the SQUID, for measuring a state ($|0'\rangle$, $|1'\rangle$) of the SQUID, the method comprising:

causing generation of phonons so as to tune the SQUID; and
measuring current flow through the SQUID using said measuring device.

**20.** A method of fabricating apparatus, the method comprising:

providing a superconducting quantum interference device (SQUID) ($1_1$; $1_2$; 79; 134) having first and second Josephson junctions and first and second phonon generators configured to control charge carrier transport through said first and second Josephson junctions respectively; and
providing a device (66; 81; 141), inductively or electrostatically coupled to the SQUID, for measuring a state ($|0'\rangle$, $|1'\rangle$) of the SQUID.

**21.** A method according to claim 20, comprising:

arranging the SQUID ($1_2$; 79; 134) and the measuring device (66; 81; 141) on a substrate (3; 120; 157).

Fig. 1

Fig. 2

Fig. 3

Fig. 4

Fig. 5

Fig. 6

Fig. 7

Fig. 8a

Fig. 9a

Fig. 8b

Fig. 9b

Fig. 8c

Fig. 9c

Fig. 8d

Fig. 9d

Fig. 8e

Fig. 9e

Fig. 8f

Fig. 9f

Fig. 8g

Fig. 9g

Fig. 8h

Fig. 9h

Fig. 8i

Fig. 9i

Fig. 10

Fig. 11

EP 1 884 791 A1

C ⋮ C'

9

$36_2$

60 { 62 61

8
7
3

## Fig. 12

D ⋮ D'

57

58

$36_2$ 36_1

8
7
3

## Fig. 13

Output
Voltage

$63_1$

$63_2$

Input magnetic flux

64

# Fig. 14

$72_1$

$72_2$

71

73

74

65    75

66

$1_2$

68    67    69

70

V

# Fig. 15

68

76

E

E'

V ~ 70

69

65

67

Fig. 16

E

77

76

9
8
7
6

66

9
8
7
6

$1_2$

3

65

z

y

Fig. 17

Fig. 18

EP 1 884 791 A1

29

EP 1 884 791 A1

## Fig. 19

Fig. 20

EP 1 884 791 A1

120

$121_1$  $121_2$  $121_3$  $121_3$

120

$112_2'$  $112_3'$  $112_4'$

$112_1'$

## Fig. 21a

116

$123_{1B}$  $123_{2B}$  $123_{3B}$  $123_{4B}$

116

$123_{1A}$  $123_{2A}$  $123_{3A}$  $123_{4A}$

$122_1$  $122_2$  $122_3$  $122_4$

$112_1$  $112_2$  $112_3$  $112_4$

## Fig. 21b

Fig. 21c

Fig. 21d

117
    $127_{2B}$    $127_{3B}$    117

$114_1$    $114_2$

$127_{2A}$    $127_{3A}$

$112_1$    $112_2$    $112_3$    $112_4$

## Fig. 21e

118
    $129_{1B}$    118    $129_{4B}$

$128_{1B}$    $128_{1B}$

$129_{1A}$    $129_{4A}$

$128_{1A}$    $128_{1A}$

$112_1$    $112_2$    $112_3$    $112_4$

## Fig. 21f

34

118

118

$112_1$    $112_2$    $112_3$    $112_4$

## Fig. 21g

130

79    80

131    132

## Fig. 22

Fig. 23

Fig. 24

Fig. 25

Fig. 26

## EUROPEAN SEARCH REPORT

European Patent
Office

Application Number

EP 06 11 8221

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,D | HUTCHINSON G.D., QIN H., KANG D.J., LEE S.B., HASKO D.G., BLAMIRE M.G., WILLIAMS D.A.: "Hot phonon controlled-junction superconducting quantum interference device" SUPERCONDUCTOR SCIENCE AND TECHNOLOGY, vol. 16, 13 November 2003 (2003-11-13), pages 1544-1549, XP002411231 * page 1544, left-hand column, paragraph 1 - right-hand column, paragraph 1 * * page 1545, right-hand column, paragraph 3 * * page 1547, left-hand column, paragraphs 2,3 * * figures 1,3 * | 1-21 | INV. G01R33/035 |
| X | HUTCHINSON G D ET AL: "CONTROLLED-JUNCTION SUPERCONDUCTING QUANTUM INTERFERENCE DEVICE VIA PHONON INJECTION" APPLIED PHYSICS LETTERS, AIP, AMERICAN INSTITUTE OF PHYSICS, MELVILLE, NY, US, vol. 84, no. 1, 5 January 2004 (2004-01-05), pages 136-138, XP001195446 ISSN: 0003-6951 * page 136, left-hand column, paragraph 2 * * page 138, left-hand column, paragraph 4 - page 139, right-hand column, paragraph 1 * | 1-21 | |
| A | US 2004/012407 A1 (AMIN MOHAMMAD H S [CA] ET AL) 22 January 2004 (2004-01-22) * paragraphs [0011], [0012], [0058], [0059] * | 1,4,6,7, 11-13, 15,19-21 | TECHNICAL FIELDS SEARCHED (IPC) G01R |

-/--

The present search report has been drawn up for all claims

| Place of search | Date of completion of the search | Examiner |
|---|---|---|
| Munich | 12 December 2006 | SCHNEIDERBAUER, K |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

**European Patent Office**

## EUROPEAN SEARCH REPORT

Application Number

EP 06 11 8221

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | HUTCHINSON G D ET AL: "Fabrication of hot phonon controlled junction microSQUIDs" MICROELECTRONIC ENGINEERING, ELSEVIER PUBLISHERS BV., AMSTERDAM, NL, vol. 73-74, June 2004 (2004-06), pages 773-779, XP004564701 ISSN: 0167-9317 * page 773 * * page 774 * * page 778 * * figures 1,2 * | 1-21 | |
| | ----- | | |
| | | | **TECHNICAL FIELDS SEARCHED (IPC)** |

The present search report has been drawn up for all claims

| Place of search | Date of completion of the search | Examiner |
|---|---|---|
| Munich | 12 December 2006 | SCHNEIDERBAUER, K |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 06 11 8221

This annex lists the patent family members relating to the patent documents cited in the above-mentioned European search report.
The members are as contained in the European Patent Office EDP file on
The European Patent Office is in no way liable for these particulars which are merely given for the purpose of information.

12-12-2006

| Patent document cited in search report | Publication date | Patent family member(s) | Publication date |
|---|---|---|---|
| US 2004012407 A1 | 22-01-2004 | NONE | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1262911 A

**Non-patent literature cited in the description**

- **K. HASSELBACH ; C. VEAUVY ; D. MAILLY.** MicroSQUID magnetometry and magnetic imaging. *Physica C,* 2000, vol. 322, 140-147
- DC-SQUID with aluminium microbridges far from T. **C. CHAPELIER ; M. EL-KHATIB ; P. PERRIER ; A. BENOIT ; D. MAILLY.** Proceedings of the 4th International Conference SQUID '91. Springer Verlag, 1992, 286-91
- **C. THIRION ; W. WERNSDORFER ; D. MAILLY.** Switching of magnetization by nonlinear resonance studied in single nanoparticles. *Nature Materials,* 2003, vol. 2, 524-527
- **W. WERNSDORFER ; K. HASSELBACH ; A. BENOIT ; B. BARBARA ; D. MAILLY ; J. TUAILLON ; J. P. PEREZ ; V. DUPUIS ; J. P. DUPIN ; G. GUIRAUD.** High sensitivity magnetization measurements of nanoscale cobalt clusters. *Journal of Applied Physics,* 1995, vol. 78, 7192
- **G. D. HUTCHINSON ; H. QIN ; S. B. LEE ; D. G. HASKO ; M. G. BLAMIRE ; D. A. WILLIAMS.** Hot phonon controlled junctions superconducting quantum interference device. *Semiconductor Science and Technology,* 2003, vol. 16, 1544